**Europäisches Patentamt**

**European Patent Office**

**Office européen des brevets**

(19)

(11) Numéro de publication : **0 014 506**
**B1**

(12)

# FASCICULE DE BREVET EUROPÉEN

(45) Date de publication du fascicule du brevet :
03.08.83

(51) Int. Cl.³ : **H 03 H 11/12, H 03 H 19/00**

(21) Numéro de dépôt : **80200080.2**

(22) Date de dépôt : **29.01.80**

---

(54) **Filtre passe-bas pour signaux basse fréquence.**

---

(30) Priorité : **02.02.79 FR 7902759**

(43) Date de publication de la demande :
**20.08.80 Bulletin 80/17**

(45) Mention de la délivrance du brevet :
**03.08.83 Bulletin 83/31**

(84) Etats contractants désignés :
**DE FR GB IT**

(56) Documents cités :
**NACHRICHTENTECHNIK-ELEKTRONIK ; vol. 25, no. 12 ; dec. 1975, Berlin DD H. UNGER : « Analoge rekursive Abtastfilter 2. Ordnung mit getakteten Integratoren », pages 457-464**

**INSTRUMENTS AND EXPERIMENTAL TECHNIQUES, vol. 20, no 2, March-April 1977 New York US B.V. CHUVYKIN : « High-quality resonance filter based on integrating discretizers », pages 461-463**

(73) Titulaire : **R.T.C. LA RADIOTECHNIQUE-COMPELEC**
**Société anonyme dite:**
**51 rue Carnot BP 301**
**F-92156 Suresnes (FR)**
**FR**
**N.V. Philips' Gloeilampenfabrieken**
**Groenewoudseweg 1**
**NL-5621 BA Eindhoven (NL)**
**DE GB IT**

(72) Inventeur : **Kaire, Jean-Claude**
**Société Civile S.P.I.D. 209 rue de l'Université**
**F-75007 (FR)**
Inventeur : **Six, Jean-Claude**
**Société Civile S.P.I.D. 209 rue de l'Université**
**F-75007 Paris (FR)**

(74) Mandataire : **Pinchon, Pierre et ai**
**Société Civile S.P.I.D. 209 rue de l'Université**
**F-75007 Paris (FR)**

## Filtre passe-bas pour signaux basse fréquence

La présente invention concerne un filtre passe-bas pour signaux basse fréquence comportant, par rapport à une valeur moyenne, des parties supérieures et des parties inférieures.

L'utilité des circuits temporisateurs sur des appareils courants du domaine que l'on dénomme « petit électro-ménager » ou grand public apparaît de plus en plus. Par ailleurs, sur ces appareils, l'intégration des circuits et leur réalisation sous forme de circuits intégrés est importante en raison de la petite taille même des équipements utilisant ces temporisateurs et des économies ainsi réalisées.

De tels appareils comportent souvent un dispositif qui produit des impulsions généralement rectangulaires séparées par un intervalle de temps défini. Ces impulsions sont reçues par un dispositif de comptage. Lorsque ce dispositif, préalablement réglé pour une durée déterminée, a reçu le nombre d'impulsions correspondant à cette durée, le temporisateur donne le signal du déclenchement de l'opération désirée.

Il est commode, pour un tel usage, d'utiliser comme référence de fréquence, on dit comme horloge, la fréquence du courant industriel qui dans les grands pays est maintenue très stable à une valeur fixée : 50 Hz en Europe, 60 Hz aux U.S.A.

Malencontreusement, si la fréquence fondamentale est maintenue stable à la source, le réseau d'alimentation est fréquemment perturbé par des parasites dont la fréquence est généralement supérieure à quelques centaines de hertz qui traversent la mise en forme de signal et qui peuvent perturber le comptage. Des parasites dans la gamme de 1 à 3 kHz sont particulièrement fréquents et gênants.

On cherche depuis longtemps à éliminer ces parasites par des filtres passe-bas, mais il est impossible, dans l'état actuel de la technique, d'intégrer de tels filtres passe-bas sur un cristal monolithique. En effet, on serait conduit à mettre en œuvre des capacités de plusieurs microfarads que l'on ne sait pas intégrer.

Par exemple la demande française 2 363 220 décrit une alimentation filtrée destinée au même usage et intégrée sauf en ce qui concerne le condensateur.

La présente invention apporte une solution à ces problèmes.

Elle prend en considération le fait qu'il s'agit principalement d'un filtrage pour circuits logiques et que l'on peut facilement, dans de tels circuits, réaliser des sources de courant de faible valeur, notamment dans la technique dite IlL ou T2 L (des termes anglais « Injection Integrated Logic »).

Il est à remarquer que l'on désigne dans ce mémoire par « électrodes principales » celles dans lesquelles circule un fort courant c'est-à-dire, dans les transistors bipolaires, l'émetteur et le collecteur que l'on distingue ainsi de l'électrode de commande constituée dans les transistors bipolaires par la base.

La présente invention concerne un filtre passe-bas pour signaux basse fréquence comportant, par rapport à une valeur moyenne, des parties dont les unes ont un sens et d'autres le sens opposé, caractérisé en ce que ledit filtre comporte notamment au moins un premier et un deuxième intégrateurs inverseurs de tension, disposés en série, le premier intégrant principalement dans les parties du deuxième sens, chaque intégrateur comportant notamment, d'une part un amplificateur de courant inverseur de tension, entre l'entrée inverseuse et la sortie duquel est inséré un condensateur tandis que l'entrée non inverseuse est à un point à tension fixe et, d'autre part, une source de courant constant d'intégration reliée à la sortie dudit amplificateur, en ce que l'entrée de chacun desdits amplificateurs est reliée à une source de courant constant de commande dudit intégrateur par l'intermédiaire d'un interrupteur commandé par un comparateur à seuil, en ce que l'entrée dudit filtre attaque le premier comparateur à seuil dudit premier intégrateur, en ce que la sortie dudit premier intégrateur attaque le deuxième comparateur à seuil dudit deuxième intégrateur, en ce que la sortie dudit deuxième intégrateur attaque un comparateur à seuil de sortie qui est relié à la sortie du filtre, et en ce que la valeur de la capacité desdits condensateurs, celle du coefficient d'amplification en courant desdits amplificateurs, celle du débit des sources de courant, celle du niveau relatif de la tension d'entrée et des tensions des seuils sont telles que le temps d'intégration de chacun desdits intégrateurs est supérieur à 0,1 et inférieur à 1 fois la durée de la plus courte des parties du signal dans lesquelles ledit intégrateur intègre et en ce que le temps de décharge de chacun desdits intégrateurs est, au plus, égal audit temps d'intégration dudit intégrateur.

La présente invention présente de nombreux avantages. Le filtrage est particulièrement efficace, en particulier en cas de parasites rapprochés et brefs. Le premier intégrateur élimine totalement des parties du signal ayant un sens donné (notamment des demi-alternances ayant un sens donné) appelé ci-dessous le premier sens (c'est-à-dire soit des parties supérieures, soit des parties inférieures) les parasites ayant une durée inférieure audit temps d'intégration dudit intégrateur. Le deuxième intégrateur associé aux comparateurs élimine une forte proportion des parasites affectant les parties du signal ou les demi-alternances ayant le sens opposé. On peut exprimer ce qui se passe en disant qu'il y a contre-réaction et que chaque fois que la tension monte à la sortie de l'amplificateur, un contre-ordre est donné à l'entrée dudit amplificateur ; ces contre-ordres agissent comme un frein et le système ne peut varier que très lentement. On peut également considérer que le condensateur shunte à la masse tout ce qui est haute fréquence et laisse la basse fréquence se transmettre.

Avantageusement ledit temps d'intégration est inférieur à 0,7 fois la durée de la plus courte des parties du signal pour lesquelles ledit intégrateur est actif.

Le dispositif est fiable. Il est, de plus, miniaturisable et intégrable dans un bloc monolithique.

Avantageusement dans ledit filtre passe-bas entre la sortie du deuxième intégrateur et l'entrée du comparateur à seuil de sortie, est inséré un intégrateur inverseur de tension additionnel comportant également :

— d'une part un amplificateur de courant inverseur de tension additionnel entre l'entrée inverseuse et la sortie duquel est placé un condensateur additionnel tandis que l'entrée non inverseuse est à un point à tension fixe,

— d'autre part une source de courant constant d'intégration additionnelle reliée à la sortie dudit amplificateur, l'entrée dudit amplificateur additionnel étant reliée à une source de courant constant de commande dudit intégrateur additionnel par l'intermédiaire d'un interrupteur commandé par un comparateur à seuil inverseur dont l'entrée est attaquée par la sortie du deuxième intégrateur, la sortie dudit intégrateur additionnel attaquant ledit comparateur à seuil de sortie dont la sortie est reliée à la sortie du filtre, et la valeur de la capacité desdits condensateurs desdits trois intégrateurs, celle du coefficient d'amplification en courant desdits amplificateurs, celle du débit des sources de courant, celle du niveau relatif de la tension d'entrée et des tensions de seuil étant telles que le temps d'intégration de chacun desdits intégrateurs est supérieur à 0,1 et inférieur ou égal à 0,5 fois la durée de la plus courte des parties du signal du deuxième sens et en ce que le temps de décharge de chacun desdits intégrateurs est, au plus, égal audit temps d'intégration dudit intégrateur.

Ce troisième intégrateur élimine notamment les parasites de grande amplitude survenant éventuellement vers le milieu des parties du signal ayant le deuxième sens (le sens opposé au sens des parties filtrées par le premier intégrateur).

En fait, les impulsions rectangulaires étant obtenues généralement en écrêtant des signaux de forme sinusoïdale, la plupart des parasites survenant au milieu de chaque demi-alternance sont éliminés ou ont une amplitude réduite par suite de l'écrêtage. Le troisième intégrateur est donc utile dans les cas où le filtrage doit être parfait.

Il est à remarquer que la présente invention utilise un montage déjà connu comme (selon une expression inexacte mais commode) « multiplicateur de capacité effective ». De tels montages dits « de Miller » sont analysés dans le paragraphe « Integration » page 78 du traité « Electronics Instruments », volume 21 de la collection « Radiation Lab. Series » publié en 1948 chez Mac Graw Hill à New-York. Ce montage a été, par exemple, appliqué dans le brevet américain 3 553 609 à l'obtention de réactances variables, but entièrement différent de celui de la présente invention.

Avantageusement, ledit temps d'intégration de chacun desdits intégrateurs est supérieur à 0,3 fois la durée de la plus courte des parties du signal pour lesquelles ledit intégrateur est actif. Ainsi, l'élimination des parasites effectivement dangereux est-elle spécialement bonne.

Pour éliminer les parasites très courts survenant dans ladite demi-alternance pour laquelle le deuxième intégrateur agit, il est favorable de disposer d'un temps de décharge des condensateurs et notamment du condensateur du premier intégrateur compris entre 0,01 et 0,2 fois la durée de la plus courte des parties du signal pour lesquelles ledit intégrateur est actif.

Cette disposition permet d'éviter la présence de l'intégrateur additionnel mentionné ci-dessus.

Lesdits parasites très courts survenant dans ladite demi-alternance pour laquelle le deuxième intégrateur agit peuvent également être éliminés en donnant au deuxième intégrateur un temps d'intégration plus long que le temps d'intégration du premier intégrateur jusqu'à, par exemple, 2 fois ce temps d'intégration.

Cette disposition peut être plus facilement réalisable que la précédente. Avantageusement, le point à tension fixe auquel est reliée l'entrée non inverseuse de l'amplificateur du premier intégrateur est le même que le point à tension fixe auquel est reliée l'entrée non inverseuse d'au moins l'un des amplificateurs des autres intégrateurs du filtre, ce qui s'implifie le montage. Il est commode que ce point commun soit à la masse.

Avantageusement, la source de courant d'intégration du premier intégrateur et la source de courant de commande du second intégrateur sont confondues, ce qui constitue une simplification et diminue la consommation d'énergie.

Préférentiellement, ledit filtre comporte une source de courant dite ci-dessous source de courant de sortie et le comparateur de sortie commande l'état, c'est-à-dire l'ouverture ou la fermeture, d'un interrupteur placé entre ladite source de courant de sortie et un branchement de sortie du filtre.

Avantageusement, ladite source de courant d'intégration du dernier intégrateur et ladite source de courant de sortie sont confondues ce qui constitue une simplification et une économie d'énergie.

Il est utile d'insérer, entre l'entrée et le premier comparateur de seuil, une diode en inverse qui évite qu'un courant extérieur venant de l'entrée, quand celle-ci est à l'état haut, ne débite dans le filtre.

Avantageusement, on utilise pour les comparateurs à seuil la même tension de référence, ce qui simplifie le montage et, préférentiellement, on réalise lesdits comparateurs à seuil et l'interrupteur qu'ils commandent au moyen d'un transistor bipolaire dont l'une des électrodes principales est à la source de courant, l'autre à l'entrée de l'amplificateur correspondant, la base étant à la tension de référence.

Pour une application à un signal symétrique, il peut être commode de prévoir des intégrateurs sensiblement identiques, ce qui simplifie la structure.

Suivant le gain en courant que l'on désire, les amplificateurs peuvent être constitués soit d'un seul transistor préférentiellement en émetteur commun, ce qui peut permettre un coefficient d'amplification en courant de l'ordre de 100 et a l'avantage de la simplicité, soit d'un montage à plusieurs transistors.

Dans une réalisation préférentielle, on utilise deux transistors bipolaires, le premier d'entrée et le deuxième de sortie, de même type, agencés selon le montage dit de « Darlington normal », l'émetteur du premier transistor dont la base constitue l'entrée dudit amplificateur attaquant la base du deuxième transistor dont l'émetteur est à la masse, les collecteurs des deux dits transistors étant reliés ensemble et à la source de courant d'intégration correspondante et constituant la sortie de l'amplificateur. Ce montage permet d'obtenir un coefficient d'amplification de courant $\beta$ élevé, de 10 000 par exemple avec des NPN ; ceci permet l'utilisation de condensateurs de très faible capacité, très facilement intégrables, et/ou le filtrage de très basses fréquences.

La présente invention est applicable au filtrage des parasites brefs sur les courants basse fréquence, notamment à fréquence industrielle, sur les dispositifs à impulsions symétriques ou non symétriques et même non périodiques, notamment sur les systèmes de transmission de données.

La description qui va suivre en regard des dessins annexés permet de mieux comprendre la présente invention et comment elle peut être réalisée et appliquée.

La figure 1 est un schéma de principe d'un filtre selon l'invention.

La figure 2 est un schéma grossièrement équivalent au filtre de la figure 1.

La figure 3 montre les différentes formes que prend un signal non parasité, symétrique à l'entrée, en différents points d'un filtre selon l'invention dans sa forme la plus générale.

La figure 4 montre l'élimination des parasites d'un signal, symétrique à l'entrée, dans un filtre selon l'invention dans sa forme la plus générale.

La figure 5 montre l'élimination de certains parasites par la prolongation du temps de décharge du premier intégrateur.

La figure 6 montre l'élimination de certains parasités par la prolongation du temps d'intégration du deuxième intégrateur.

La figure 7 est un schéma de principe d'un filtre selon l'invention comportant trois intégrateurs.

La figure 8 montre l'élimination de certains parasites par le filtre représenté figure 7.

La figure 9 représente un signal d'entrée périodique en forme d'impulsions.

La figure 10 représente un signal d'entrée non périodique en forme d'impulsions.

La figure 11 est le schéma d'une réalisation d'un filtre selon l'invention dans laquelle les amplificateurs sont réalisés avec des transistors bipolaires.

La figure 12 représente cinq variantes 12A, 12B, 12C, 12D, 12E, de réalisation des amplificateurs.

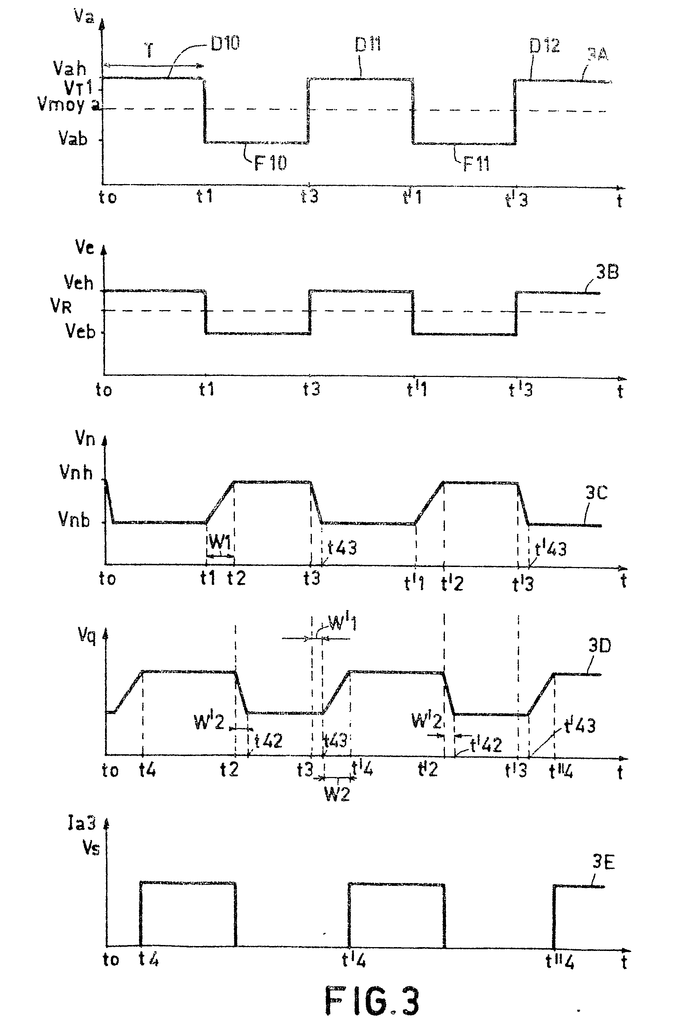

Il est à remarquer que, pour rendre les figures plus claires, les proportions ne sont pas observées, notamment figure 3 en ce qui concerne les temps de décharge des condensateurs.

Les transistors NPN des schémas ci-dessous peuvent être remplacés le plus souvent par des transistors PNP et inversement. Les changements que cela implique sont à la portée de l'homme de l'art.

Il est à remarquer, par ailleurs, que dans les figures et les raisonnements qui suivent les parties supérieures du signal sont du « premier sens » c'est à dire filtrées totalement par le premier intégrateur. Il doit être clair que cela pourrait être l'inverse, les comparateurs de seuil notamment étant inversés.

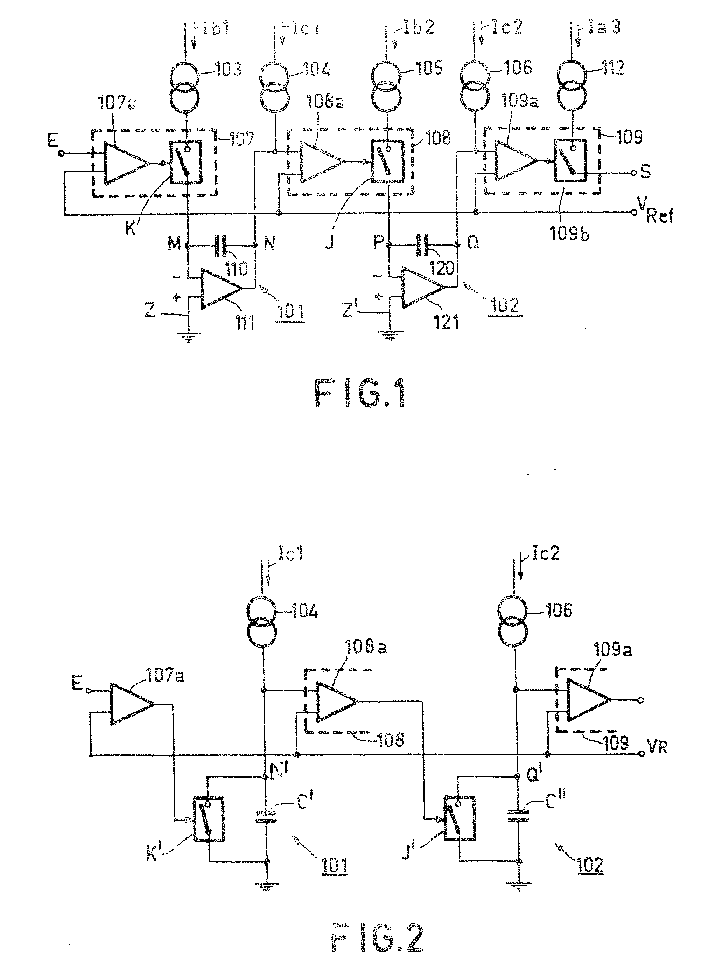

Sur la figure 1, on a représenté en 101 et 102, les deux intégrateurs en série du filtre constitués chacun, d'une part par un amplificateur de courant inverseur de tension 111, 121 dont l'entrée non inverseuse Z, Z' est à la masse, et dont l'entrée inverseuse M, P et la sortie N, Q sont rebouclées par un condensateur 110, 120 et, d'autre part, par une source à courant constant d'intégration 104, 106 reliée à la sortie N, Q de l'amplificateur correspondant. Ces deux sources débitent respectivement les courants $I_{c1}$ et $I_{c2}$.

L'entrée inverseuse M, P de chacun desdits amplificateurs est reliée, par l'intermédiaire d'un ensemble 107, 108 constitué d'un interrupteur K, J commandé par un comparateur à seuil 107a, 108a, à une source à courant constant de commande 103, 105. Ces deux sources débitent respectivement un courant $I_{b1}$, $I_{b2}$.

Les armatures des condensateurs reliées à M ou P sont dites ci-dessous « première armature », celles reliées à N ou Q étant dites « deuxième armature ».

L'entrée E du filtre qui reçoit la tension d'alimentation $V_a$ attaque l'entrée du premier comparateur 107a, la sortie N du premier intégrateur attaque l'entrée du deuxième comparateur 108a du deuxième intégrateur ; la sortie Q dudit deuxième intégrateur attaque un comparateur de sortie 109a qui commande un interrupteur 109b, l'ensemble des deux étant désigné par 109. L'interrupteur 109b commande le passage ou le blocage du courant $I_{a3}$ de la source de courant de sortie 112, ce qui constitue la sortie du filtre. La sortie du filtre est, en fait, l'état du comparateur 109a. On le relève au point S.

Naturellement, le seuil $V_{T1}$ du premier comparateur 107a doit être compris entre le niveau haut $V_{ah}$ et le niveau bas $V_{ab}$ de la tension d'alimentation $V_a$. La tension qui sort du comparateur est désignée ci-dessous par $V_e$. Le niveau bas $V_{nb}$ de la sortie $V_n$ du premier intégrateur est inférieur au seuil $V_{T2}$ du deuxième comparateur et le niveau bas $V_{qb}$ de la sortie $V_q$ du deuxième intégrateur

est inférieur au seuil $V_{T3}$ dudit comparateur de sortie. Les niveaux hauts $V_{nh}$, $V_{qh}$ sont égaux ou supérieurs aux niveaux des seuils respectifs $V_{T2}$ et $V_{T3}$. Ces trois comparateurs sont commandés par une même tension de référence $V_R$.

Il est à remarquer que le fonctionnement du circuit selon l'invention est expliqué ci-dessous à partir d'une tension d'entrée en créneau. Le choix de cette forme de tension par rapport à la sinusoïde facilite l'explication du fonctionnement du circuit sans, pour autant, restreindre l'application à ce type de forme d'onde. Une tension d'alimentation $V_a$ sinusoïdale à l'entrée est du reste transformée en tension en créneau par le comparateur de seuil 107a. De ce fait, les parasites situés au milieu de chaque demi-alternance sont déjà éliminés ou leur importance a été réduite. Sur une tension industrielle de 220 V, les parasites ont rarement une amplitude supérieure à 100 V.

Lorsqu'un condensateur de capacité C est disposé entre l'entrée et la sortie d'un dispositif, simultanément amplificateur de courant et inverseur de tension, dont le coefficient d'amplification en courant est β et dont l'entrée non inverseuse est à la masse, il apparaît entre la sortie dudit amplificateur et la masse un effet dit « effet Miller ».

Tout se passe comme si on avait remplacé l'ensemble constitué de l'amplificateur, du condensateur qui le reboucle et de l'interrupteur à seuil, par un ensemble constitué d'un condensateur de capacité βC branché entre sortie et masse en parallèle avec un interrupteur à seuil. Par exemple, pour une variation de tension $dV_c$ sur l'armature N de sortie du condensateur 110 de capacité C, la charge électrique équivalente est égale à $C\beta dV_c$. Si la source 104 débite un courant $I_{c1}$, le condensateur aura reçu cette charge après un temps d'intégration $W = C\beta dV_c/I_{c1}$. Ce temps doit avantageusement être compris entre le tiers et 0,7 fois la plus courte des parties du signal pour lesquelles ledit intégrateur est actif, c'est-à-dire le tiers et 0,7 fois la demi-alternance d'un signal périodique symétrique.

Pour simplifier les explications, on a représenté sur la figure 2 un schéma grossièrement équivalent au filtre. On considère d'abord, par exemple, l'intégrateur 101 dans lequel on retrouve un condensateur C', la source à courant constant d'intégration 104, débitant un courant $I_{c1}$, le comparateur de sortie de cet intégrateur 108a, le point N' exactement équivalent à N, le comparateur 107a de l'ensemble 107 et un interrupteur K' qui n'est que grossièrement équivalent à l'interrupteur K car, le point M n'existant plus, ses bornes ne sont pas les mêmes.

De même, on retrouve pour l'intégrateur 102 un condensateur C'', la source de courant constant d'intégration 106, débitant un courant $I_{c2}$, le comparateur de sortie du filtre 109a, le point Q' exactement équivalent à Q et un interrupteur J' qui n'est que grossièrement équivalent à l'interrupteur J, car le point P n'existant plus, ses bornes ne sont pas les mêmes.

Tout se passe comme si C' et C'' avaient des valeurs équivalentes à β'C et β''C, β' et β'' étant les coefficients d'amplification en courant des deux amplificateurs respectivement.

Quand on ferme l'interrupteur K (ou K'), le point N descend à la masse. Quand on ouvre K (ou K'), la capacité C' se charge par le courant $I_{c1}$ selon la loi $I_{c1}dt = CdV_c$.

Il en est de même dans le deuxième intégrateur pour l'interrupteur J (ou J'), le point Q, la capacité C'' et pour le courant $I_{c2}$.

Le calcul suivant est fait pour le premier intégrateur :

si $C = 3$ pF, $\beta' = 10\,000$, $I_{c1} = 3\ \mu A$, $dV_c = 1$ volt on a $C' = \beta'C = 10\,000 \times 3 \times 10^{-12} = 3 \cdot 10^{-8}$ Farads $= 0,03\ \mu F$

et $dt = 3 \cdot 10^{-8} / 3 \cdot 10^{-6} = 10$ millisecondes par volt, c'est-à-dire, pour une fréquence de 50 Hertz, la demi-alternance.

La limitation du courant de charge à une très petite valeur permet donc de donner au temps que cette charge met à s'établir une durée comparable à celle de la demi-alternance de la fréquence à filtrer, la valeur optimale étant la moitié de cette demi-alternance. Cette limitation, en s'opposant à la charge rapide de la capacité empêche la transmission des parasites brefs gênants.

Les parasites que l'on désire éliminer par le filtre sont ceux qui altéreraient le comptage, c'est-à-dire ceux qui, pendant le temps où K' ou K est ouvert, équivalent à une brève fermeture de K' ou de K et ceux qui, pendant le temps où K' ou K est fermé, équivalent à une brève ouverture de K' (ou de K). Ces parasites ont tendance à détruire la situation commandée par la tension d'entrée. Ces parasites sont ceux qui, au cours d'une alternance positive, étant négatifs, feraient passer le dispositif à l'état bas et, ceux qui, au cours d'une alternance négative, étant positifs, feraient passer le dispositif à l'état haut.

Les parasites qui ont, au contraire, tendance à maintenir la situation commandée par l'entrée sont sans inconvénient et ne sont pas transmis.

Un signal qui entre en E doit, pour sortir en S, suivre le chemin suivant : E, ensemble 107, points M, N, ensemble 108, points P, Q, comparateur 109, point S. Pour que ce signal soit éliminé, il suffit qu'en un point du parcours il ne soit pas transmis.

Les courbes de la figure 3 représentent, en fonction du temps $T_o$, l'évolution de la forme de la tension d'un signal en créneau, symétrique à l'entrée, de période 2T, qui traverse le filtre selon l'invention. La courbe 3A représente la tension d'alimentation $V_a$ comportant autour d'une valeur moyenne $V_{moya}$ des parties supérieures et des parties inférieures. La courbe 3B représente la tension $V_e$ qui sort du comparateur d'entrée, la courbe 3C la tension $V_n$ à la sortie N du premier intégrateur, la courbe 3D la tension $V_q$ à la sortie Q du deuxième intégrateur, la courbe 3E le courant $I_{a3}$ ou la tension $V_s$ de sortie. Chacune de ces tensions comporte un niveau haut indicé h et un niveau bas indicé b.

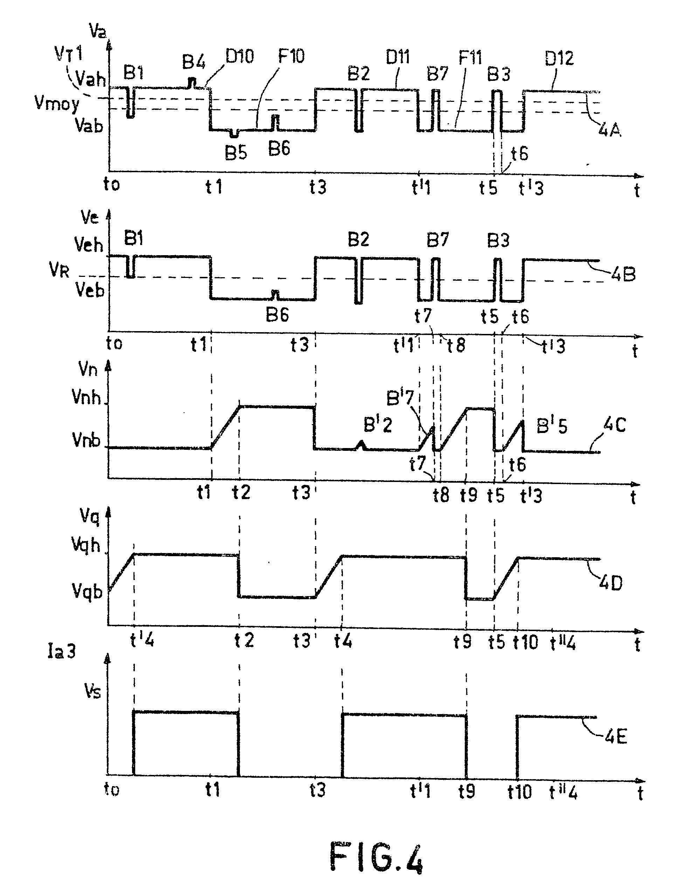

Sur la figure 3 en liaison avec la figure 1 comme sur les figures 4, 5, 6, 8, 9, 10, 12, les demi-alternances et parties du signal correspondant à un niveau haut $V_{ah}$ de la tension d'alimentation $V_a$ sont du premier sens, c'est-à-dire filtrées par le premier intégrateur 101 de la figure 1. On pourrait avec un inverseur et/ou un comparateur 107 fonctionnant de manière opposée avoir l'inverse, le raisonnement serait le même.

La figure 3 s'étend sur trois demi-alternances du premier sens désignées respectivement par D10, D11, D12 et qui respectivement commencent en $t_0$, en $t_3$ en $t'_3$ et dont les deux premières se terminent en $t_1$ et $t'_1$. Les demi-alternances correspondant à un niveau bas $V_{ab}$ de la tension d'alimentation sont du deuxième sens. La figure 3 en comporte 2 désignées par F10 et F11 qui respectivement commencent en $t_1$ et en $t'_1$ et se terminent en $t_3$ et $t'_3$.

On a porté sur la figure 3A la valeur de la tension $V_{T1}$ de seuil du premier comparateur 107a, elle est supérieure à la valeur du niveau bas $V_{ab}$ de la tension d'alimentation.

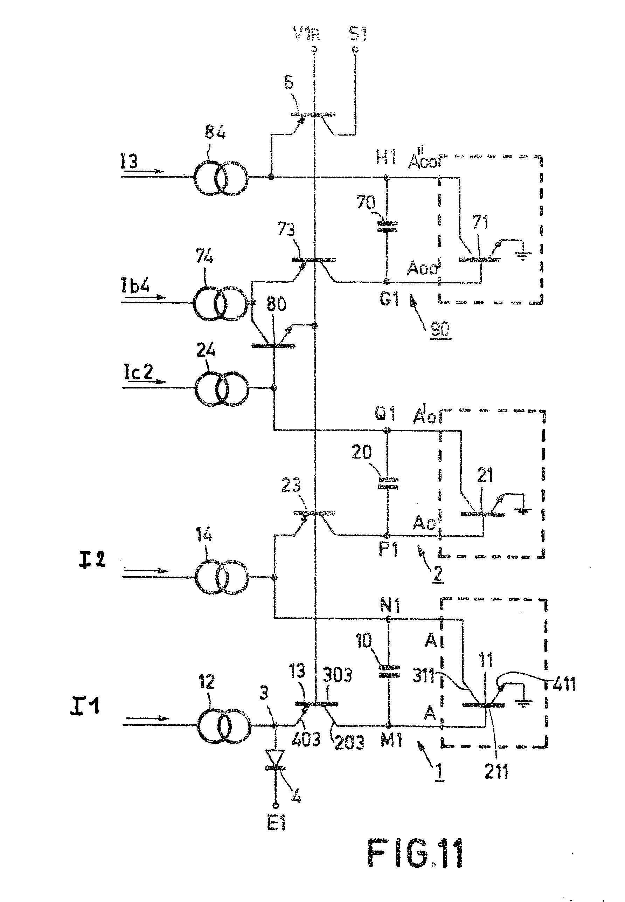

Par ailleurs, la tension de référence $V_R$ est comprise entre $V_{eh}$ et $V_{eb}$. Sur la figure 3, $V_{eb}$ est représenté d'une manière générale c'est-à-dire avec une valeur non nulle. Dans la réalisation dont le schéma est donné figure 11, $V_{eb}$ est égal à zéro. Lorsque la tension $V_e$ est à son niveau haut, $V_{eh}$, par exemple entre $t_0$ et $t_1$, elle ferme l'interrupteur KK' et la capacité équivalente C' est court-circuitée ; le courant de la source 104 s'écoule alors directement à la masse, la tension $V_n$ est à son niveau bas $V_{nb}$.

Lorsque, au temps $t_1$, la tension $V_e$ passant à son niveau bas $V_{eb}$ commande l'ouverture de l'interrupteur KK', la capacité équivalente C' se charge, la tension au point NN' monte, mais cette montée est ralentie par la faiblesse de la valeur du courant $I_{c1}$ et dure de $t_1$ à $t_2$ un temps $W_1$. Au temps $t_2$ la tension en N, $V_n$, atteint son niveau haut $V_{nh}$ dont la valeur est celle du seuil $V_{T2}$ du deuxième comparateur 108a. Le temps d'intégration $W_1$ égal à $t_2 - t_1$ est inférieur à $t_3 - t_1$ c'est-à-dire à T, durée de la demi-alternance, et égal sur la figure 3 au tiers de celle-ci. La charge du condensateur 110 (C') et le niveau de la tension en N, $V_{nh}$, restent alors inchangés du temps $t_2$ au temps $t_3$ fin de la demi-alternance F10 du deuxième sens.

Dès que, en $t_3$, la tension $V_e$ repasse à son niveau haut $V_{eh}$, l'interrupteur KK' se referme, le condensateur 110 (C') se décharge et la tension en NN' revient à son niveau bas $V_{nb}$ en $t_{43}$. Le temps de décharge $W'_1$ est le temps compris entre $t_3$ et $t_{43}$.

La décharge s'effectue à la masse à travers l'amplificateur 111 par le courant $I_{b1}$ selon l'équation $dV_c = I_{b1}dt$ ; donc, si $I_{b1} = I_{c1}$, elle est $\beta$ fois plus courte que la charge, c'est-à-dire, si $\beta = 100$, presque instantanée. On peut prolonger le temps de décharge $W'_1$ en diminuant $I_{b1}$ ou $\beta$.

La courbe 3D représente la tension en Q à la sortie du deuxième intégrateur qui fonctionne exactement comme le premier intégrateur. Lorsque, au cours de l'alternance F10 entre $t_2$ et $t_3$, la tension en N est au niveau haut, l'interrupteur JJ' est fermé et la capacité équivalente C'' est court-circuitée, la tension en Q, $V_q$, est à son niveau bas $V_{qb}$, le courant de la source 106 s'écoule alors directement à la masse.

Lorsque, par exemple au temps $t_3$, la tension $V_n$ passant à son niveau bas $V_{nb}$ commande l'ouverture de l'interrupteur JJ', la capacité C'' se charge, la tension au point QQ' monte, et cette montée, ralentie par la faible valeur du courant $I_{c2}$, dure de $t_{43}$ à $t'_4$ un temps $W_2$ inférieur à la demi-alternance T et égal, sur la figure 3, au tiers de celle-ci. ($t'_4$ et $t''_4$ désignent des points homologues à $t_4$ pour d'autres demi-alternances).

Au temps $t_4$, la tension en Q atteint son niveau haut $V_{qh}$ dont la valeur est celle du seuil $V_{T3}$ du troisième comparateur 109a. Tant que $V_n$ reste au niveau bas, $V_{nb}$, l'interrupteur JJ' reste ouvert et la charge du condensateur 120 C'' reste inchangée.

Quand $V_n$, par exemple en $t_1$, commence à quitter son niveau bas, $V_{nb}$, l'interrupteur JJ' reste ouvert et la charge du condensateur 120 C'' reste inchangée jusqu'à ce que le point N atteigne en $t'_2$ son niveau haut $V_{nh}$ dont la valeur est celle de la tension de seuil $V_{T3}$ du comparateur de seuil 109a. Quand $V_n$ atteint son niveau haut en $t'_2$ (ou en $t_2$) l'interrupteur JJ' se ferme, la capacité C'' équivalente au condensateur 120 se décharge en un temps $W'_2$ qui va de $t'_2$ à $t'_{42}$. La tension $V_q$ passe à son niveau bas $V_{qb}$.

La courbe 3E représente le courant de sortie $I_{a3}$ débité par la source 112 ou la tension de sortie $V_S$ aux bornes d'une résistance placée dans cette sortie entre le point S et le point commun non représentée sur la figure.

Quand la tension en Q, $V_q$, est inférieure à la tension de seuil $V_{T3}$ du comparateur de sortie 109a, l'interrupteur 109b est ouvert, aucun courant venant de la source $I_{a3}$ ne passe dans la sortie.

Quand la tension en Q, $V_q$ devient égale à $V_{T3}$ c'est-à-dire, quand elle atteint son niveau haut $V_{qh}$, la source 112 fournit à la sortie S un courant $I_{a3}$ si la logique qui suit nécessite une attaque en tension, on insère entre la sortie S et la masse une résistance non représentée sur la figure et on relève une tension $V_S$ au point S.

La figure 4 représente l'évolution du signal de la figure 3 (constitué par les demi-alternances D10, F10, D11, F11, D12), quand celui-ci porte des parasites. Contrairement à la figure 3 on a gardé la même échelle pour le temps de décharge, généralement très court, si bien que celui-ci n'apparaît pas sur les figures.

Le signal de la figure 4 porte les parasites $B_1$ et $B_4$ sur D10, $B_2$ sur D11, demi-alternances du premier sens, $B_5$ et $B_6$ sur F10, $B_7$ et $B_3$ sur F11 demi-alternances du deuxième sens.

Les parasites dangereux survenant en KK' sont, pendant que $V_a$ est à son niveau haut $V_{eh}$, ceux qui, étant négatifs, commanderaient l'ouverture de l'interrupteur et, pendant que $V_a$ est à son

niveau bas $V_{ab}$, ceux qui, étant positifs, commanderaient la fermeture de l'interrupteur.

Les parasites négatifs survenant pendant que $V_a$ est à son niveau haut $V_{ah}$ et qui auraient tendance à ouvrir KK' ne peuvent, s'ils sont brefs, et en raison de la limitation drastique du courant par la source de courant 104, faire monter la tension en N' à un niveau suffisant pour que le comparateur 108a ne réagisse.

Quand, au cours d'une demi-alternance du premier sens, KK' est fermé et que N est à la masse, la limitation du courant $I_{c1}$ à une valeur très faible empêche la charge rapide de la capacité 110 (C') et donc la transmission des parasites brefs gênants qui sont éliminés.

Le parasite $B_4$ a tendance à maintenir la situation commandée par l'entrée, il est donc sans inconvénient.

L'amplitude du parasite $B_1$ (inférieure à $V_{eh} - V_{eb}$) est insuffisante pour ouvrir l'interrupteur K, ce parasite n'est donc pas transmis à la tension en N.

L'amplitude du parasite $B_2$ (égale ou supérieure à $V_{eh} - V_{eb}$) serait suffisante pour ouvrir l'interrupteur K, mais la valeur très faible du courant $I_{c1}$ limite la variation de la tension en N à une valeur très faible, fonction de la durée du parasite $B_2$. Ce parasite se traduit en N par la minuscule montée de tension $B'_2$. Celle-ci restant de valeur très inférieure à celle de $V_{nh}$ définie par le seuil $V_{T2}$ du comparateur 108a, n'est pas transmise. Il est clair qu'un parasite succédant immédiatement à $B_1$ ou à $B_2$ serait éliminé de la même manière.

La figure 4 est tracée pour le cas où le temps d'intégration est inférieur à la moitié de la durée des parties du signal du premier sens (ici une demi-alternance), l'élimination des parasites des parties du premier sens est la même si le temps d'intégration est supérieur à ladite moitié.

Sur la première demi-alternance F10 du deuxième sens le parasite $B_5$ a tendance à maintenir la situation commandée par l'entrée, il est donc sans inconvénient.

Les parasites positifs brefs survenant pendant que $V_a$ est à son niveau bas $V_{ab}$ et qui sont d'une amplitude inférieure à $(V_{eh} - V_{eb})$, par exemple $B_6$, ne sont pas transmis à N.

Par contre, les parasites positifs brefs survenant pendant que $V_e$ est à son niveau bas $V_{eb}$, et qui sont d'une amplitude égale ou supérieure à l'écart entre le niveau du seuil et $V_{eb}$ ($V_{T1} - V_{eb}$) sont transmis en N.

Deux exemples en sont donnés figure 4 par le parasite $B_3$ qui apparaît au temps $t_5$ et disparaît au temps $t_6$ et par le parasite $B_7$ qui apparaît au temps $t_7$ et disparaît au temps $t_8$. De tels parasites engendrent à leur apparition une décharge de la capacité 110 (C') et une chute de $V_n$ jusqu'à son niveau bas. $V_n$ reste à son niveau bas $V_{nb}$ jusqu'à la fin dudit parasite. A ce moment commence une nouvelle charge de la capacité C'. En ce qui concerne $B_3$ cette charge est interrompue par la fermeture de KK'. En ce qui concerne $B_7$ cette charge permet à N d'atteindre au temps $t_9$ le niveau $V_{nh}$.

Les conséquences de la présence d'un tel parasite varient avec la valeur de la durée de ladite demi-alternance et du temps d'intégration du premier intégrateur et avec la situation du parasite au cours de ladite demi-alternance du deuxième sens.

Dans le cas où ledit temps d'intégration est inférieur à la moitié de ladite demi-alternance du deuxième sens (cas de la figure 4), si le parasite survient au début où à la fin de ladite demi-alternance, à une distance de l'extrémité de celle-ci inférieure au temps d'intégration $W_1$, la tension au point N passe par un petit pic, $B'_7$ et $B'_5$, inférieur à $V_{nh}$ qui ne traverse pas le comparateur 108a. L'impulsion de sortie correspondant à la demi-alternance ayant porté les parasites est raccourcie, mais cela est sans inconvénient car le nombre des impulsions n'est pas modifié, le comptage reste bon. En effet, dans le cas de $B_7$, le moment $t_9$ où la tension en N atteint $V_{nh}$ étant retardé, le moment où JJ' se ferme est également retardé. Dans le cas de $B_3$ le moment $t_{10}$ où la tension en N atteint $V_{nh}$ étant avancé, le moment où JJ' s'ouvre est également avancé.

Il est clair que des parasites brefs successifs sont éliminés de la même manière.

De même, d'une manière réciproque, dans le cas où ledit temps d'intégration $W_1$ est supérieur à la moitié desdites parties du deuxième sens (demi-alternance pour un signal régulier), si le parasite survient au début ou à la fin de ladite partie à une distance de l'extrémité inférieure à la différence entre la durée de ladite demi-alternance et le temps d'intégration, le nombre des impulsions n'est pas modifié, le comptage est bon.

Il est très rare qu'un parasite important survienne au milieu d'une des impulsions et notamment d'une demi-alternance dans le cas d'un signal régulier ; le courant industriel sous 220 V comporte rarement des parasites de plus de 100 V. Ces parasites sont donc sans effet sur le comparateur d'entrée et sont donc éliminés de ce fait.

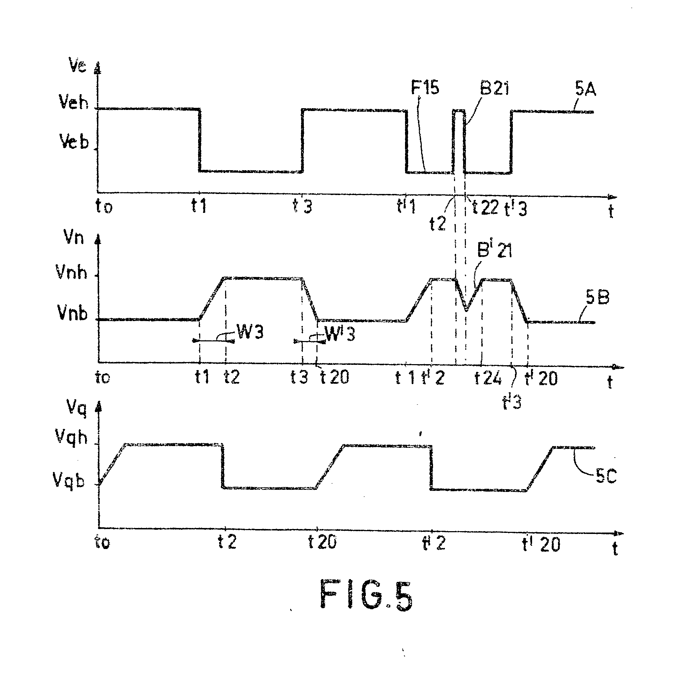

Sur la figure 5, on a représenté courbe 5 A, la tension $V_e$ portant au milieu de la deuxième demi-alternance du deuxième sens, F15, un parasite $B_{21}$ d'amplitude égale à la différence entre le niveau haut $V_{eh}$ et le niveau bas $V_{eb}$. Ce parasite survient au temps $t_{21}$ et se termine au temps $t_{22}$, la durée $t_{22} - t_{21}$ étant, par exemple, de l'ordre de 0,01 et 0,1 fois la durée de la demi-alternance.

La courbe 5B représente la tension en N dans le cas où le temps $W'_3$ de décharge du condensateur du premier intégrateur est le tiers de son temps de charge $W_3$. Quand, en $t_3$, l'interrupteur K se ferme, la tension $V_n$ descend de $V_{nh}$ à $V_{nb}$ en un temps égal à $t_{20} - t_3$.

Quand, en $t_{21}$, le parasite $B_{21}$ paraît, la décharge du condensateur commence, mais elle n'est pas terminée et $V_n$ est supérieur à $V_{nb}$ quand, en $t_{22}$, le parasite $B_{21}$ se terminant $V_e$ atteint de nouveau $V_{eb}$. Le condensateur se recharge et la tension en N atteint $V_{nh}$ en $t_{24}$. Le

parasite $B_{21}$ est transformé en $B'_{21}$, qui n'atteint pas $V_{nb}$.

La courbe 5C représente la tension en Q pour un deuxième intégrateur à décharge immédiate. Le crochet $B'_{21}$ de $V_n$ n'a aucune influence sur $V_q$.

Il peut donc être intéressant de disposer d'intégrateurs ayant un temps de décharge allant jusqu'à 0,2 fois la durée de la plus courte des parties pour lequel ledit intégrateur est actif.

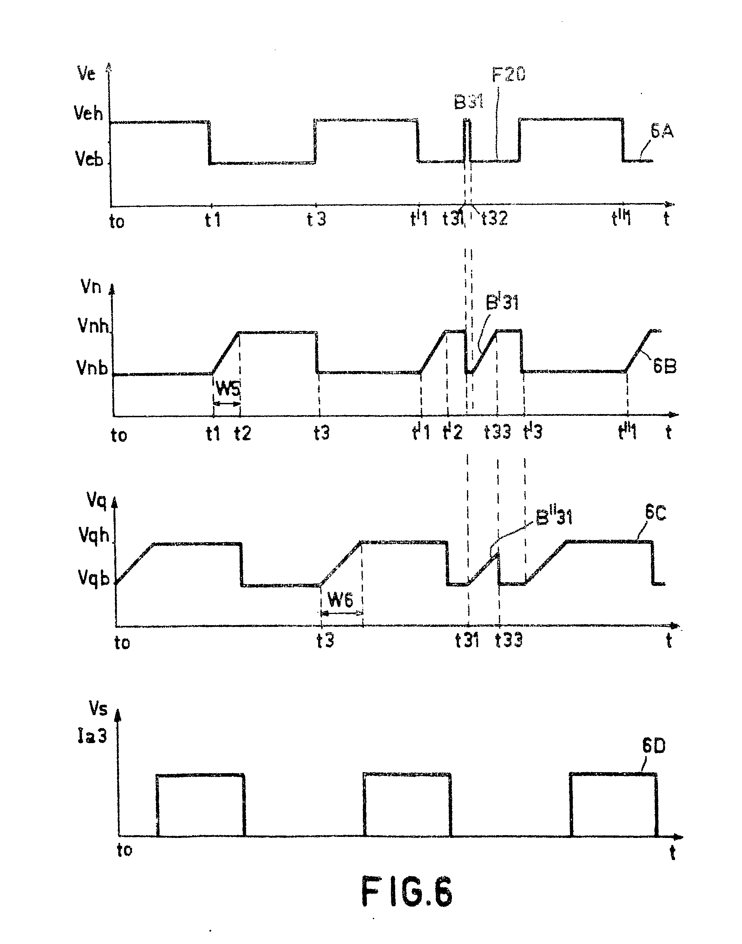

Sur la figure 6 on a représenté courbe 6 A la tension $V_e$ portant au milieu de la deuxième demi-alternance du deuxième sens F20 un parasite $B_{31}$ d'amplitude égale à la différence entre le niveau haut $V_{eh}$ et le niveau bas $V_{eb}$.

Ce parasite survient au temps $t_{31}$ et se termine au temps $t_{32}$, la durée $t_{32} - t_{31}$ étant brève au regard du temps d'intégration du premier intégrateur.

La courbe 6B représente la tension en N pour un premier intégrateur dont le temps d'intégration $W_5$ est le tiers de la demi-alternance. En $t_{31}$, le parasite $B_{31}$ en fermant l'interrupteur K fait chuter $V_n$ de $V_{nh}$ à $V_{nb}$. En $t_{32}$, l'interrupteur K s'ouvre et la tension en N, $V_n$, augmente jusqu'à $V_{nh}$ qu'elle atteint en $t_{33}$ et où elle reste jusqu'au temps $t'_3$. Le parasite $B'_{31}$ dure donc de $t_{31}$ à $t_{33}$.

La courbe 6C représente la tension en Q pour un deuxième intégrateur dont le temps d'intégration $W_6$ est plus long que celui du premier intégrateur, soit, sur la figure, les 2/3 de la demi-alternance.

Au temps $t_{31}$, la chute de $V_{nh}$ à $V_{nb}$ amorce une charge du condensateur 120. Le temps d'intégration $W_6$ du deuxième intégrateur étant supérieur à la somme, $t_{33} - t_{31}$, de la durée du parasite $t_{32} - t_{31}$ et du temps d'intégration $W_5$ du premier intégrateur, cette charge est interrompue avant que $V_q$ n'atteigne $V_{qh}$. De ce fait, le parasite $B''_{31}$ est refusé par le comparateur de sortie. La courbe 6D représente la sortie. Le comptage n'est pas perturbé.

Il peut donc être intéressant de doter le deuxième intégrateur d'un temps d'intégration compris entre 1 fois et 2 fois le temps d'intégration du premier intégrateur.

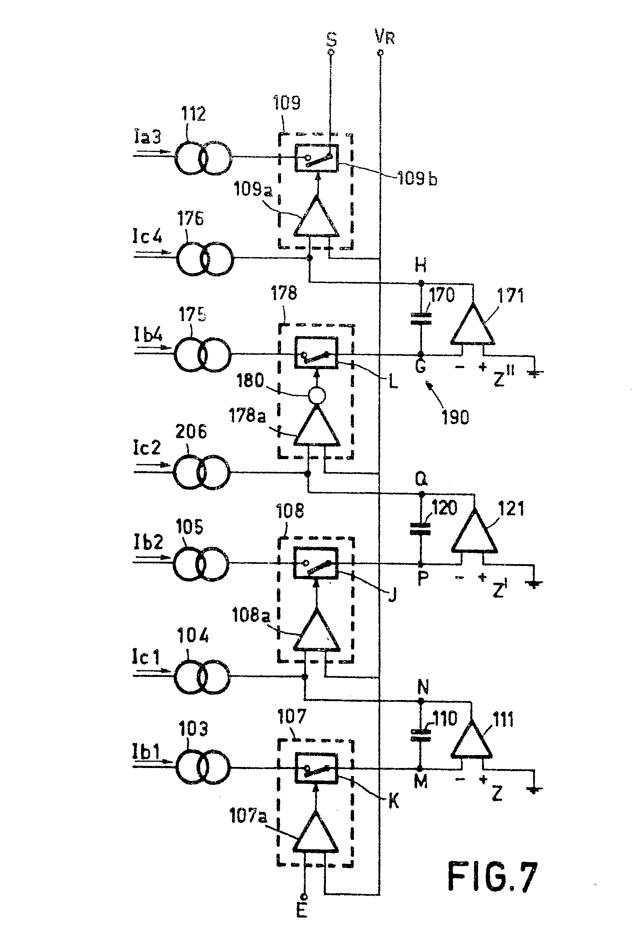

On peut éliminer à coup sûr tous les parasites en choisissant des intégrateurs ayant une durée d'intégration inférieure ou égale à 0,5 fois la durée des parties ou demi-alternances du deuxième sens et en ajoutant entre la sortie du deuxième intégrateur et le comparateur à seuil de sortie un ensemble intégrateur-inverseur de tension additionnel analogue ou identique auxdits premier et deuxième intégrateurs et précédé d'un inverseur. Sur la figure 7 on a représenté le dispositif de la figure 1 auquel on a ajouté entre la sortie Q du deuxième intégrateur et le comparateur de sortie 109a un intégrateur additionnel 190. Les éléments déjà présents figure 1 portent ici les mêmes numéros hormis la source de courant d'intégration du deuxième intégrateur numérotée ici 206.

L'intégrateur additionnel 190 est constitué, d'une part, par un amplificateur de courant inverseur de tension 171 dont l'entrée non inverseuse $Z''$ est à la masse et dont l'entrée inverseuse G et la sortie H sont rebouclées par un condensateur 170 et, d'autre part, par une source à courant constant d'intégration 176 débitant un courant $I_4$ et reliée à la sortie H de l'amplificateur 171.

L'entrée inverseuse G de l'amplificateur est reliée par l'intermédiaire d'un ensemble 178 constitué d'un interrupteur L commandé par un comparateur à seuil 178a et d'un inverseur 180 à une source à courant constant de commande 175 débitant un courant $I_{b4}$.

L'entrée du comparateur à seuil 178a est commandée par la sortie Q du deuxième intégrateur, le comparateur étant relié par ailleurs à la tension de référence $V_R$. La sortie H de l'intégrateur 190 est reliée à l'entrée du comparateur de sortie 109a.

L'intégrateur 190 fonctionne exactement comme les précédents.

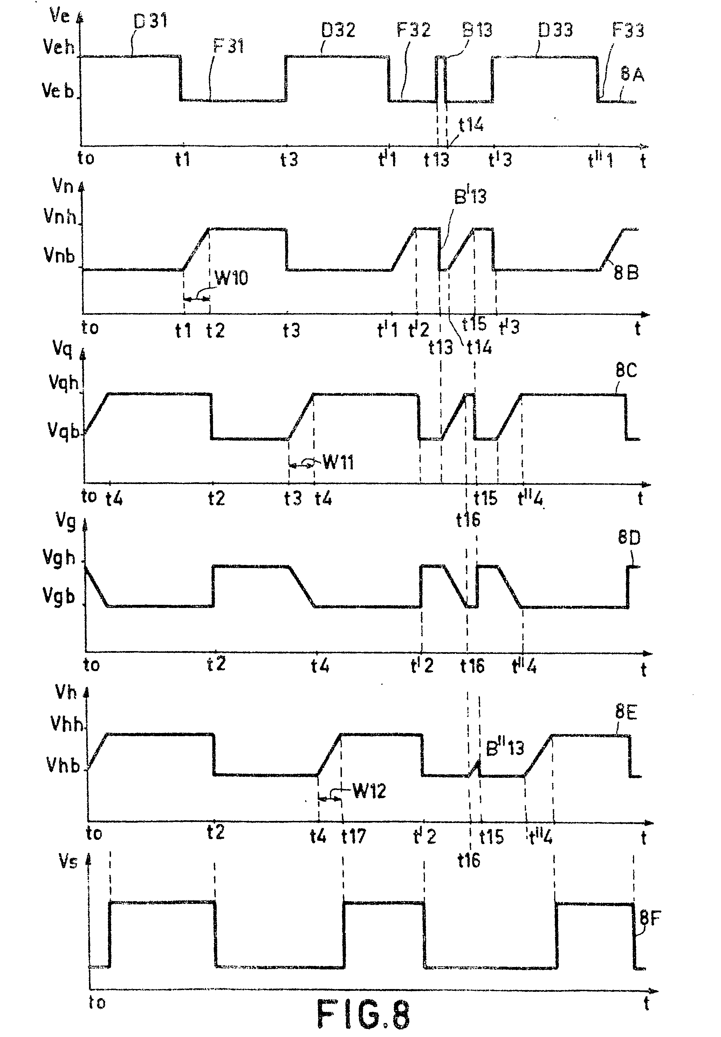

Sur la figure 8 on a représenté, en fonction du temps t, courbe 8A, trois alternances de la tension de demi-alternance T à l'entrée, $V_e$, (dont le niveau haut est $v_{eh}$ et le niveau bas $V_{eb}$). Les premières (D31 de $t_0$ à $t_1$), troisième (D32 de $t_3$ à $t'_1$), cinquième (D33 de $t'_3$ à $t''_1$) demi-alternances ont le premier sens, c'est-à-dire qu'elles sont filtrées par le premier intégrateur 101. Les deuxième (F31 de $t_1$ à $t_3$), quatrième (F32 de $t'_1$ à $t'_3$) et sixième (F33 à partir de $t''_1$) demi-alternances ont le deuxième sens. On a figuré au milieu de F32 un parasite $B_{13}$ qui commence en $t_{13}$ et se termine en $t_{14}$ et dont l'amplitude est égale à $V_{eh} - V_{eb}$.

La courbe 8B représente la tension en N, $V_n$ dont le niveau haut est $V_{nh}$ et le niveau bas $V_{nb}$. Le temps d'intégration du premier intégrateur est $W_{10} = t_2 - t_1$. Il est de l'ordre du tiers de T. Le temps de décharge $W'_{10}$ est presque nul, la décharge étant presque instantanée.

Au temps $t_{13}$, la tension $V_e$ atteignant $V_{eh}$, l'interrupteur KK' se ferme, $V_n$ qui était à son niveau haut depuis le temps $t'_2$, s'effondre de $V_{nh}$ à $V_{nb}$, puis, à partir de $t_{14}$, l'interrupteur KK' s'ouvre, le condensateur 110 se charge et $V_n$ atteint de nouveau le niveau $V_{nh}$ au temps $t_{15}$, $t_{15}$ étant avant $t'_3$, instant à partir duquel la demi-alternance étant terminée $V_n$ repasse à son niveau bas. Le parasite $B_{13}$ est transformé en $B'_{13}$ qui coupe en deux une demi-alternance.

La courbe 8C représente la tension en q, $V_q$, dont le niveau haut est $V_{qh}$ et le niveau bas $V_{qb}$. Le temps d'intégration du deuxième intégrateur est $W_{11} = t_4 - t_3$. Il est de l'ordre du tiers de T. Le temps de décharge $W'_{11}$ est également pratiquement nul.

La tension en Q qui, jusqu'en $t'_2$, était à son niveau haut $V_{qh}$, chute alors par suite de la fermeture de l'interrupteur J, à son niveau bas $V_{qb}$ où elle reste jusqu'en $t_{13}$.

Lorsque, en $t_{13}$, le parasite $B_{13}$, en faisant chuter la tension $V_n$ de son niveau haut à son niveau bas, commande l'ouverture de l'interrupteur JJ', le condensateur 120 se met à se charger progressivement et la tension $V_{qb}$ passe de son niveau bas à son niveau haut $V_{qh}$ qu'elle atteint éventuellement en $t_{16}$ et où elle se maintient jusqu'en $t_{15}$.

En $t_{15}$, $V_{nh}$ atteignant son niveau haut commande la fermeture de l'interrupteur J et $V_q$ repasse à son niveau bas $V_{qb}$ où il reste jusqu'en $t'_3$, moment à partir duquel le condensateur 120 se recharge jusqu'à ce que, en $t''_4$, la tension en Q atteigne son niveau haut $V_{qh}$ où elle se maintient pendant toute la durée de la troisième demi-alternance du premier sens D33.

La courbe 8 D représente la tension en G dont la forme est exactement l'inverse de la tension en Q.

La courbe 8 E représente la tension en H, $V_h$ qui évolue d'un niveau haut $V_{hh}$ à un niveau bas $V_{hb}$. Le temps d'intégration du troisième intégrateur W12 est égal à $t_{17} - t_4$. Il est de l'ordre du tiers de t. Le temps de décharge $W'_{12}$ est pratiquement nul.

En $t_2$, le niveau $V_{gh}$ de tension en G commande la fermeture de l'interrupteur L et la tension en H passe à son niveau bas $V_{hb}$ où elle reste jusqu'en $t_4$. $V_g$ qui a quitté son niveau haut en $t_3$ atteignant son niveau bas en $t_4$, l'interrupteur L s'ouvre et le condensateur 170 commence à se charger jusqu'en $t_{17}$, temps auquel $V_h$ atteint son niveau haut $V_{hh}$ où il reste jusqu'au temps $t'_2$.

Au temps $t'_2$, $V_g$ passant à son niveau haut, $V_{gh}$, commande la fermeture de l'interrupteur L, la tension en H s'effondre et reste à son niveau bas jusqu'en $t_{16}$. En $t_{16}$, la tension en G atteignant son niveau bas commande l'ouverture de L, mais la charge du condensateur 170 est interrompue en $t_{15}$ par une nouvelle fermeture de L qui dure jusqu'en $t''_4$. Le parasite important $B_{13}$ est donc transformé en un parasite minime $B''_{13}$ d'une amplitude trop faible pour passer au comparateur 109a.

La courbe 8F représente la tension de sortie dont le nombre d'impulsions est le même que celui de la tension d'entrée. Le comptage n'est donc pas perturbé par le parasite $B_{13}$.

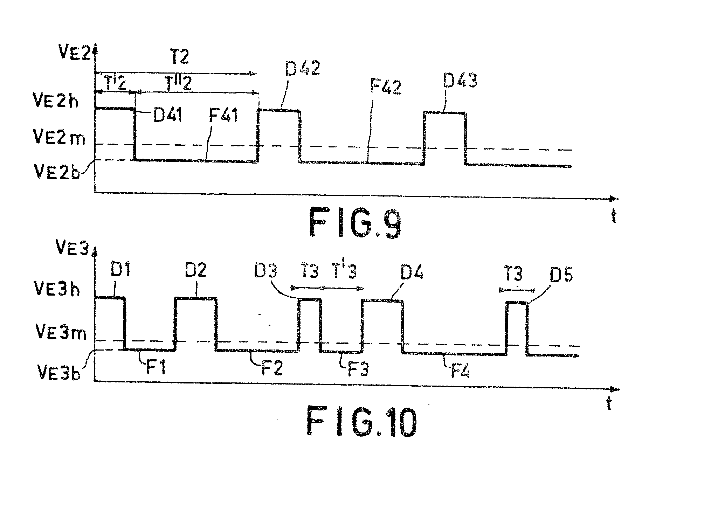

La figure 9 représente un signal périodique de période de $T_2$ comportant des parties (D41, D42, D43) en forme d'impulsions de tension brèves d'une durée $T'_2$ (rapport cyclique $R_1 = T'_2/T_2$), d'un niveau $V_{E2h}$ supérieur sur la figure à une valeur moyenne $V_{E2m}$ et des parties (F41, F42) en forme d'impulsions longues d'une durée $T''_2$ (rapport cyclique $R_2 = T''_2/T_2$) d'un niveau $V_{E2b}$ inférieur sur la figure à ladite valeur moyenne.

Pour filtrer un signal de cette forme, les deux intégrateurs du filtre selon la présente invention doivent être préférentiellement différents, le temps d'intégration de l'intégrateur intégrant les impulsions brèves étant préférentiellement compris entre 0,30 et 1 fois la durée $T'_2$ de ladite impulsion brève, et le temps d'intégration de l'intégrateur intégrant les impulsions longues étant compris entre 0,30 et 1 fois la durée $T''_2$ de ladite impulsion longue. Les intégrateurs sont calculés exactement comme il a été dit ci-dessus.

La présente invention est applicable à tous les rapports cycliques.

La figure 10 représente un signal non périodique de transmission de données, comportant cinq impulsions, D1, D2, D3, D4, D5, de durée variable dont le niveau haut est $V_{E3h}$ supérieur à une valeur moyenne $V_{E3m}$. La durée des plus courtes D3 et D5 a une valeur connue $T_3$. Lesdites impulsions positives sont séparées par des intervalles F1, F2, F3, F4 de durée également variable de niveau $V_{E3b}$ inférieur à $V_{E3m}$ dont le plus court F3 a également une valeur connue $T'_3$.

Pour filtrer un signal de cette forme, avec un dispositif selon la présente invention, l'intégrateur destiné à filtrer les impulsions D1, D2, D3 peut avantageusement avoir un temps d'intégration compris sensiblement entre 0,3 et 1 fois la durée $T_3$ de l'impulsion la plus courte D5, et l'intégrateur destiné à filtrer le signal pendant les intervalles entre les impulsions peut avoir un temps d'intégration sensiblement compris entre 0,3 et 1 fois la durée $T'_3$ de l'intervalle F3 le plus court.

Les transistors NPN des schémas décrits ci-dessous peuvent être remplacés le plus souvent par des transistors PNP et inversement ; les changements que cela implique sont à la portée de l'homme de l'art.

Sur la figure 11, on a représenté en 1 le premier intégrateur inverseur, en 2 le deuxième et en 90 un intégrateur inverseur additionnel précédé du comparateur de seuil inverseur 80.

Le premier intégrateur comporte notamment un condensateur 10 dont une première armature est reliée en $M_1$ à la base 211 du transistor NPN amplificateur 11 monté en émetteur commun, dont le collecteur 311 est à la sortie et ledit émetteur 411 à la masse.

La deuxième armature dudit condensateur 10 est reliée en $N_1$ au collecteur 311 dudit transistor 11.

Ledit premier intégrateur comporte également la source à courant constant d'intégration $I_4$ reliée au point $N_1$.

Par ailleurs, la source à courant constant de commande 12 est reliée au point commun $M_1$ par l'intermédiaire du transistor PNP 13, à l'émetteur 403 duquel elle est connectée en 3, tandis que le collecteur 203 dudit transistor interrupteur 13 est relié au point $M_1$. Le transistor 13 joue à lui seul le rôle de l'ensemble 107 de la figure 1 constitué de l'interrupteur K commandé par le comparateur à seuil 107a, la base 303 étant commandée par la tension de référence $V_{1R}$.

Le deuxième intégrateur comporte notamment un condensateur 20 dont une première armature est reliée en $P_1$ à la base du transistor NPN amplificateur 21 monté en émetteur commun, ledit émetteur étant à la masse et dont la deuxième armature est reliée en $Q_1$ au collecteur dudit transistor 21.

Ledit deuxième intégrateur comporte également la source à courant constant d'intégration 24 reliée au point $Q_1$. Par ailleurs, la source 14 est reliée au point $P_1$ par l'intermédiaire du transistor PNP interrupteur 23 à l'émetteur duquel elle est connectée tandis que le collecteur dudit transistor interrupteur 23 est connecté au point $P_1$ et sa base à la tension de référence $V_{1R}$.

La source 14 joue donc, en plus du rôle de source à courant constant d'intégration du premier intégrateur, le rôle de source à courant constant de commande du deuxième intégrateur, le transistor 23 jouant le rôle de l'ensemble 108 comme le transistor 13 joue le rôle de l'ensemble 107.

L'intégrateur additionnel 90 comporte notamment un condensateur 70 dont une première armature est reliée en $G_1$ à la base du transistor NPN amplificateur 71 monté en émetteur commun, ledit émetteur étant à la masse et dont la deuxième armature est reliée en $H_1$ au collecteur dudit transistor 71.

Ledit intégrateur additionnel comporte également la source à courant constant d'intégration 84 reliée au point $H_1$, et une source 74 à courant constant de commande $I_{b4}$. La source 74 est reliée au point commun $G_1$ par l'intermédiaire du transistor PNP 73 à l'émetteur duquel elle est connectée, tandis que le collecteur dudit transistor interrupteur 73 est connecté au point $G_1$. Le transistor 73 joue le rôle de l'interrupteur.

Entre le deuxième intégrateur et l'intégrateur additionnel est placé le comparateur de seuil inverseur 80. Plus précisément la sortie $Q_1$ du deuxième intégrateur attaque la base du transistor inverseur 80 de type NPN dont l'émetteur est à la tension de référence $V_{1R}$ et le collecteur, alimenté par la source 74 du courant $I_{b4}$, est relié à l'émetteur du transistor interrupteur 73.

La source à courant constant 84 est connectée non seulement au point $H_1$ mais également à l'émetteur du transistor 6 dont le collecteur est relié à la sortie et dont la base est à la tension de référence $V_{1R}$. Le transistor 6 joue le rôle de l'ensemble 109 (comparateur de sortie 109a et interrupteur 109b) et la source à courant constant 84 le rôle de la source de sortie 112. La source de courant 84 joue donc, comme la source 14, deux rôles et la sortie du filtre est en $S_1$.

Le point commun 3 entre l'émetteur du transistor 13 et la source de courant 12 constitue l'entrée du filtre proprement dit. Cette entrée est précédée d'une diode 4 qui la sépare de la borne d'entrée $E_1$ et qui évite qu'un courant extérieur venant de ladite entrée ne débite, quand elle est à l'état haut, dans le filtre.

Les quatre transistors 13, 23, 73 et 6 sont montés en base commune, leur émetteur étant relié aux sources de courant (respectivement 12, 14, 74 et 84) et le collecteur des trois premiers (13, 23 et 73) à la première armature du condensateur correspondant tandis que le collecteur du transistor 6 constitue la sortie. Leurs bases sont alimentées en parallèle par la tension de référence $V_{1R}$.

Il est à remarquer que, dans ce montage, les seuils de tension $V_T$ des comparateurs interrupteurs 13, 23, 73 et 6 sont décalés par rapport à $V_{1R}$ de la valeur $V_{EB}$ de la tension interne de la jonction entre émetteur et base ; ils sont donc égaux à $V_{1R} + 0,5$ V valeur à laquelle le niveau haut $V_{E1h}$ de la tension d'entrée doit être supérieur et le niveau bas de la tension d'entrée inférieur.

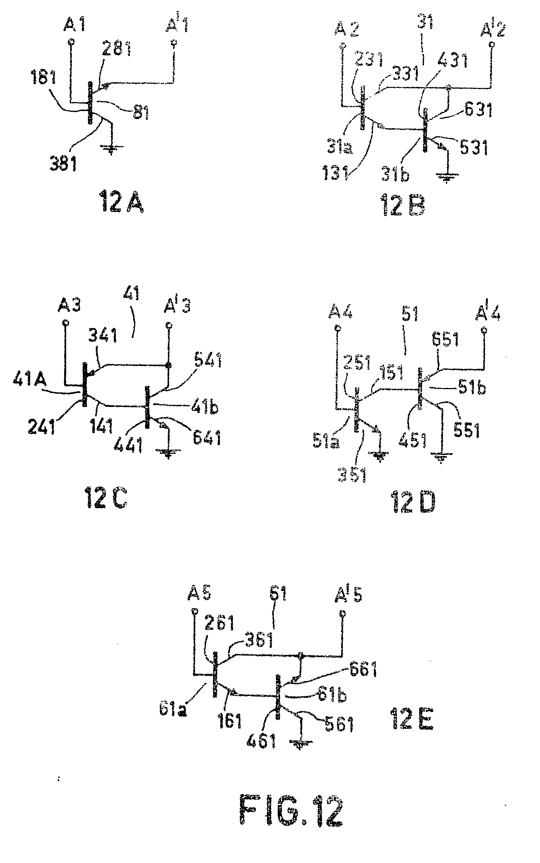

Les transistors 11, 21, 71 sont placés chacun dans un encadré car ils peuvent être remplacés par un des montages décrits ci-dessous en regard de la figure 12 inséré entre les couples de points A et A', $A_o$ et $A'_o$, $A_{oo}$ et $A'_{oo}$. Les tensions en $E_1$, $M_1$, $N_1$, $O_1$, $Q_1$, $H_1$, $S_1$ sont désignées par $V_{E1}$, $V_{M1}$, $V_{P1}$, $V_{Q1}$, leur niveau haut indicé h et leur niveau bas indicé b, la tension appliquée sur les bases des transistors 13, 23, 73, et 6, dite tension de référence, par $V_{1R}$, les tensions internes des jonctions émetteur base par $V_{BE}$ et les tensions internes entre l'émetteur et le collecteur d'un transistor par $V_{CE}$ (et en saturation par $V_{CEsat}$) indicés supplémentairement par le numéro du transistor considéré.

Lorsque le transistor interrupteur 13 n'est pas passant, les sources de courant 12 et 14 peuvent donner du courant et $V_{1R}$ est appliqué. Il en est de même pour les transistors interrupteurs 23 et 73, les sources de courant en cause étant 14 et 24 d'une part 74 et 84 d'autre part. Les niveaux hauts sont les suivants :

$V_{M1h} = V_{P1h} = V_{G1h} = V_{BE21} = V_{BE71} = 0,7$ V

En effet, le courant ne peut passer dans la connexion de base du transistor 11, du transistor 21 ou du transistor 71 que quand le transistor correspondant conduit.

$N_1$, $Q_1$, $H_1$, sont à leur niveau haut égal à $V_T$ quand les transistor 11, 21 et 71 ne conduisent pas

$V_{N1h} = V_{Q1h} = V_{H1h} = V_{1R} + V_{BE} (23, 73, 6) = V_{1R} + 0,5$ V $= V_T$ et, si $V_{1R} = 3$ V, $V_T = V_{N1h} = V_{Q1h} = V_{H1h} = 3,5$ V.

La tension de seuil $V_T$ qui doit être inférieure au niveau haut du signal d'entrée (5 volts par exemple), doit également être supérieure à la tension sur les bases des transistors amplificateurs 11, 21, et 71 quand ceux-ci sont en conduction (0,7 V).

Les niveaux bas sont les suivants :

$V_{M1b} = V_{P1b} = V_{G1b} = 0,6$ V en régime normal.

Les tensions en $M_1$, $P_1$, $G_1$, varient peu, passant juste de part et d'autre de la tension interne de la jonction émetteur base des transistors 11, 21 et 71 car il ne s'agit pas d'un fonctionnement saturé bloqué. Les choses sont un peu différentes au moment du démarrage mais cela est sans importance pour le but de la présente invention.

$V_{N1b} = V_{Q1b} = V_{G1b} = V_{CEsat}$ du transistor correspondant $= 0,1$ volt.

Quand $N_1$, $Q_1$ et $G_1$ sont à leur niveau bas, le transistor correspondant est en saturation et la base de celui-ci est au niveau haut.

Quand la première armature d'un condensateur est à son niveau haut (0,7 V) la deuxième armature dudit condensateur est à son niveau bas (0,1 V) et le condensateur est chargé dans un sens tel que ladite première armature soit à une tension plus élevée que ladite deuxième armature.

Quand la tension sur la première armature dudit condensateur tombe au-dessous de 0,7 V (par exemple à 0,6 V), le transistor correspondant se désature et, en raison de l'effet « Miller », cette désaturation est lente ; la tension sur la deuxième armature augmente jusqu'à son niveau haut (3,5 V). Le condensateur se décharge puis se recharge dans le sens inverse au précédent, sa deuxième armature atteignant une tension plus élevée que la première armature. La variation de charge équivalente correspondant à la variation de potentiel de $N_1$ de 3,4 V est alors, pour un condensateur de 3 pF et un $\beta$ de 100, de 1 nanocoulomb.

Pour le premier intégrateur, lorsque la tension d'entrée passe à son niveau haut, par exemple 5 volts, le transistor 13 qui était bloqué devient passant, le courant $I_1$ issu de la source 12 circule dans la branche $M_1$, le condensateur 10 se charge très rapidement, la durée de la charge dépendant de l'intensité du courant $I_1$ fourni par la source 12. La tension en $M_1$ passe rapidement de son niveau bas à son niveau haut et devient supérieure à la tension en $N_1$ qui passe de son niveau haut à son niveau bas. Le transistor 11 passe à l'état de saturation et le courant $I_2$ issu de la source 14 circule dans la branche $N_1$.

Lorsque le régime est établi, le courant $I_1$ cesse de circuler dans la branche $M_1$ et s'écoule par la diode 4 et l'entrée $E_1$.

Le transistor 11 reste saturé pendant pratiquement une demi-alternance de la tension d'entrée, que celle-ci dure 1 milliseconde ou 10 millisecondes, la tension en $N_1$ étant à son niveau bas et le courant $I_2$ circulant constamment dans la branche $N_1$.

Lorsque la tension d'entrée $V_{E1}$ tombe à zéro, le transistor 13 qui était passant se bloque, le courant $I_1$ ne circule plus dans la branche $M_1$ et s'écoule par la diode 4 et l'entrée $E_1$. La lente désaturation du transistor 11 mentionnée ci-dessus commence. Au cours de cette désaturation, la tension en $M_1$ décroît lentement jusqu'à son niveau bas et la tension en $N_1$ monte à son niveau haut, le courant $I_2$ s'écoule dans la branche $N_1$ (le transistor 23 n'est pas passant) et décharge le condensateur 10 de la charge qu'il porte et le recharge en sens contraire du sens précédent, la tension en $N_1$ devenant plus élevée que la tension en $M_1$. Avec les valeurs de charge données ci-dessus et un courant $I_2$ de 3 $\mu$A cette désaturation dure 0,3 milliseconde. Il est à remarquer que le temps d'intégration fixe la valeur de $I_2$ mais que la valeur de $I_1$ peut être beaucoup plus faible 10 ou 15 fois si $\beta = 1\,000$. En fait, on donne à $I_1$ la même valeur qu'à $I_2$ pour des raisons de simplicité.

Après la fin de la période de désaturation, les tensions en $M_1$ et en $N_1$ restent stables tant que la tension d'entrée $V_{E1}$ reste à l'état bas. Aucun courant ne circule ni dans la branche $M_1$ ($I_1$ s'écoulant par la diode 4 et l'entrée E), ni dans la branche $N_1$ ($I_2$ passant dans la branche $P_1$ du fait que lorsque $N_1$ a atteint son niveau haut de 3,5 V le transistor 23 s'est débloqué).

Cet état dure jusqu'à ce que la tension d'entrée $V_{E1}$ passe à l'état haut et que, le transistor 13 devenant passant, le courant $I_1$ décharge le condensateur 10 et le recharge en sens contraire, la tension en $N_1$ décroît du niveau haut au niveau bas, la tension en $M_1$ croît, le cycle recommence.

Le second intégrateur fonctionne exactement comme le premier et le troisième intégrateur fonctionne comme les précédents à ceci près que le transistor NPN 80 joue le rôle de comparateur et d'inverseur et que le transistor PNP 73 joue uniquement celui d'interrupteur du courant de commande $I_{b4}$. A la sortie le transistor PNP 6 joue simultanément le rôle du comparateur de sortie et celui de l'interrupteur de sortie.

Dans le schéma de la figure 11, les transistors 11, 21 et 71 qui constituent les amplificateurs 111, 121 et 171 de la figure 7 et qui, figure 11, sont dans un encadré, peuvent être remplacés par les différents montages représentés figure 12 insérés entre les points A et A', $A_0$ et $A'_0$ ou $A_{00}$ et $A'_{00}$, l'entrée en A, en $A_0$, ou en $A_{00}$ et la sortie en A', en $A'_0$ ou en $A'_{00}$.

Dans le montage 12A, lesdits amplificateurs sont constitués d'un transistor bipolaire 81 dont la base 181 constitue l'entrée $A_1$, monté également en émetteur commun, mais dont l'émetteur 281 et le collecteur 381 sont inversés, l'émetteur 281 étant relié à la deuxième armature du condensateur et donc à la sortie $A'_1$ de l'amplificateur et le collecteur 381 étant à la masse. Dans ce cas, l'amplification en courant $\beta$ est de l'ordre de 5.

Dans le montage 12B, les amplificateurs sont constitués d'un ensemble 31 de deux transistors bipolaires de même type, le premier $31_a$ d'entrée, le deuxième $31_b$ de sortie, tous deux en émetteurs communs, agencés selon le montage dit « Darlington normal », l'émetteur 131 du premier transistor dont la base 231 constitue l'entrée $A_2$ dudit amplificateur attaquant la base 431 du deuxième transistor dont l'émetteur 531 est à la masse.

La base 231 du transistor d'entrée est réunie à la première armature du condensateur correspondant, les collecteurs 331 et 631 sont réunis à la sortie $A'_2$ et à la deuxième armature dudit condensateur. Le coefficient d'amplification en courant est égal au produit des coefficients en courant des deux transistors qui, puisque ceux-ci sont des NPN, est compris pour chacun d'eux entre 80 et 200. Le transistor d'entrée travaillant à très faible courant, son amplification peut être plus faible, soit entre 60 et 100. Le coefficient d'amplification du Darlington est donc entre 4 800 et 20 000. En fait, la valeur des condensateurs étant connue à $\pm$ 20 %, on peut se fixer par exemple un $\beta$ de l'ordre de 6 000 à 7 000. De ce fait, la « capacité équivalente » à un condensateur de 3 picofarads est de l'ordre de 20 nanofarads (avec les valeurs ci-dessus, entre 15 et 25).

Avec une source de courant d'intégration de 3 $\mu$A, les temps d'intégration $W_{15}$ et $W_{16}$ sont de l'ordre de 7 millisecondes par volt aux bornes du condensateur.

Dans l'exemple ci-dessus, parfaitement réalisable, la variation du potentiel sur la borne $N_1$ du

condensateur est de 3 V environ, la durée d'intégration serait donc de l'ordre de 21 millisecondes, c'est-à-dire plus longue qu'une demi-alternance pour la fréquence de 50 Hz (10 millisecondes).

La facilité d'obtenir avec un amplificateur « Darlington normal » une telle durée d'intégration en fait une solution préférentielle pour le filtrage des très basses fréquences. Il est clair qu'une durée d'intégration qui prolonge la charge du condensateur au-delà de la demi-alternance de la fréquence à conserver éliminerait celle-ci. Il suffit, pour filtrer par exemple le courant industriel, de diminuer l'amplification β et/ou d'augmenter la valeur du courant d'intégration ; un courant un peu plus élevé permettant d'obtenir des sources plus reproductibles, on bénéficie d'un avantage supplémentaire.

De la durée d'intégration dépend la valeur de la fréquence de coupure au-dessus de laquelle les parasites sont éliminés ; sont éliminées les fréquences supérieures à la fréquence correspondant à la durée d'intégration.

Dans les montages figure 12C et figure 12D, les amplificateurs 41 figure 12C et 51 figure 12D sont constitués d'ensembles dits « Darlington mixte » de deux transistors de types opposés, l'un d'entrée, l'autre de sortie, le collecteur du transistor d'entrée attaquant la base du transistor de sortie.

Dans le montage 12C, l'entrée $A_3$ de l'amplificateur 41 se fait sur la base 241 du transistor d'entrée $41_a$ qui est un PNP dont l'émetteur 341 est relié à la deuxième armature du condensateur et au collecteur 541 du transistor de sortie $41_b$, point qui constitue la sortie $A'_3$ de l'amplificateur. Le collecteur 141 du transistor d'entrée attaque la base 441 du transistor de sortie. L'émetteur 641 du transistor de sortie est à la masse.

Dans le montage 12D, l'entrée $A_4$ de l'amplificateur 51 se fait sur la base 251 du transistor d'entrée $51_a$ qui est un NPN dont l'émetteur 351 est à la masse. Le transistor de sortie $51_b$ est un PNP dont le collecteur 551 est à la masse et dont l'émetteur 651 est relié à la sortie $A'_4$ de l'amplificateur. Le collecteur 151 du transistor d'entrée attaque la base 451 du transistor de sortie.

Du fait que les PNP ont toujours un coefficient d'amplification en courant plus faible que les NPN, le coefficient d'amplification en courant (produit des coefficients d'amplification en courant des deux transistors qui le constituent) est de l'ordre de 1 000. De ce fait, la « capacité équivalente » à un condensateur de 3 pF est de 3 nF, et, avec une source de courant d'intégration de 2 μA, la durée d'intégration serait de 4,5 millisecondes.

Cette durée d'intégration est tout à fait favorable au filtrage d'un courant des fréquences industrielles européenne ou américaine.

Dans certains cas, les montages « Darlington mixtes » peuvent présenter des avantages topologiques.

Dans la configuration 12E, les amplificateurs 61 sont constitués d'un ensemble de deux transistors de même type (NPN sur la figure) l'un d'entrée $61_a$, l'autre de sortie $61_b$. Dans cette configuration, l'entrée $A_5$ se fait sur la base 261 du transistor d'entrée. « L'émetteur 161 de ce transistor attaque la base du transistor de sortie » dont le collecteur 561 est à la masse. Le collecteur 361 du transistor d'entrée et l'émetteur 661 du transistor de sortie sont réunis tous deux à la deuxième armature du condensateur correspondant et constituent la sortie $A'_5$ de l'amplificateur.

Dans cette configuration, le coefficient d'amplification en courant du transistor d'entrée étant de l'ordre de 80, et celui du transistor de sortie de l'ordre de 5, celui de l'ensemble est de l'ordre de 400. Avec un condensateur de 3 pF et un courant d'intégration de 2 μA, la durée d'intégration est de 0,6 millisecondes.

Le filtre selon la présente invention peut être réalisé en éléments discrets. Il peut également et avantageusement être réalisé sous forme de circuit intégré monolithique : les différents éléments peuvent être intégrés, par exemple, dans un monocristal de silicium dont le substrat d'un premier type de conduction (P par exemple) porte une couche épitaxiale de type opposé (N par exemple) partagée en caissons isolés les uns des autres. La réalisation du dispositif ne fait appel qu'à des techniques très connues : épitaxie, diffusion, métallisation, qu'il est inutile de décrire dans ce mémoire. Les condensateurs ayant une capacité de quelques picofarads nécessaires à la réalisation de l'invention sont facilement réalisables, notamment par la technique dite MOS (métal oxyde semiconducteur) bien connue dans le domaine des circuits intégrés. C'est la possibilité d'utiliser des condensateurs de si faible valeur et, de ce fait, intégrables, qui constitue un des avantages principaux de la présente invention.

**Revendications**

1. Filtre passe-bas pour signaux basse fréquence comportant, par rapport à une valeur moyenne, des parties dont les unes ont un sens et d'autres ont le sens opposé, ledit filtre comportant notamment un premier (101) et un deuxième (102) intégrateurs inverseurs de tension, disposés en série, le premier (101) intégrant principalement dans les parties d'un premier sens, le deuxième (102) intégrant dans les parties du deuxième sens, chacun de ces intégrateurs comportant notamment un amplificateur de courant inverseur de tension (111, 121) entre l'entrée inverseuse (M, P) et la sortie (N, Q) duquel est inséré un condensateur (110, 120) tandis que l'entrée non inverseuse (Z, Z') est à un point à tension fixe, caractérisé en ce que le premier (101) et le deuxième (102) intégrateurs comportent également une source de courant constant d'intégration (104, 106) reliée à la sortie (N, Q) dudit amplificateur, en ce que l'entrée (M, P) de chacun desdits amplificateurs est reliée à une source de courant constant de commande (103, 105) dudit intégrateur par l'intermédiaire d'un interrupteur (K, J) commandé par un comparateur à seuil (107a, 108a), en ce que l'entrée (E) dudit filtre attaque le premier comparateur à seuil (107a) dudit premier intégrateur (101), en ce que la sortie (N) dudit premier intégrateur (101) attaque le deuxième comparateur à seuil (108a) dudit deuxième intégrateur (102), en ce que la sortie (Q) dudit deuxième intégrateur (102) attaque un comparateur à seuil de sortie (109a) qui est relié à la sortie (S) du filtre, et en ce que la valeur de la capacité desdits condensateurs (110, 120), celle du coefficient d'amplification en courant desdits amplificateurs (111, 121), celle du débit des sources de courant (103, 105, 104, 106), celle du niveau relatif de la tension d'entrée et des tensions des seuils des comparateurs (107a, 108a, 109a) sont telles que le temps d'intégration de chacun desdits intégrateurs est supérieur à 0,1 et inférieur à 1 fois la durée de la plus courte des parties du signal dans lesquelles ledit intégrateur intègre, et en ce que le temps de décharge de chacun desdits intégrateurs est, au plus, égal audit temps d'intégration dudit intégrateur.

2. Filtre passe-bas selon la revendication 1, caractérisé en ce que entre la sortie (Q) du deuxième intégrateur (102) et l'entrée du comparateur à seuil de sortie (109a) est inséré un intégrateur inverseur de tension additionnel (90) comportant également :

— d'une part, un amplificateur de courant inverseur de tension additionnel (171) entre l'entrée inverseuse (G) et la sortie (H) duquel est placé un condensateur additionnel (170) tandis que l'entrée non inverseuse est à un point à tension fixe et

— d'autre part, une source (176) de courant constant d'intégration additionnelle reliée à la sortie (H) dudit amplificateur, en ce que l'entrée (G) dudit amplificateur additionnel (171) est reliée à une source (175) de courant constant de commande dudit intégrateur additionnel par l'intermédiaire d'un interrupteur (L) commandé par un comparateur à seuil (178a) inverseur (180) dont l'entrée est attaquée par la sortie (Q) du deuxième intégrateur,

et en ce que la sortie (H) dudit intégrateur additionnel attaque ledit comparateur à seuil de sortie (109a) dont la sortie est reliée à la sortie du filtre (S), et en ce que la valeur de la capacité desdits condensateurs (110, 120, 170) desdits trois intégrateurs, celle du coefficient d'amplification en courant desdits amplificateurs, celle du débit des sources de courant (103, 104, 105, 206, 175, 176), celle du niveau relatif de la tension d'entrée et des tensions de seuil des comparateurs (107a, 108a, 178a, 109a) sont telles que le temps d'intégration de chacun desdits intégrateurs est supérieur à 0,1 et inférieur ou égal à 0,5 fois la durée de la plus courte des parties du signal ayant le deuxième sens et en ce que le temps de décharge de chacun desdits intégrateurs est, au plus, égal audit temps d'intégration dudit intégrateur.

3. Filtre selon l'une quelconque des revendications 1 et 2, caractérisé en ce que le temps d'intégration desdits intégrateurs est supérieur à 0,3 fois la durée de la plus courte des parties du signal pour lesquelles ledit intégrateur intègre.

4. Filtre selon la revendication 1, caractérisé en ce que le temps d'intégration desdits intégrateurs est inférieur à 0,7 fois la durée de la plus courte des parties du signal pour lesquelles ledit intégrateur intègre.

5. Filtre selon l'une quelconque des revendications 1 à 4, caractérisé en ce que au moins le temps de décharge du condensateur (110) du premier intégrateur (101) est compris entre 0,01 et 0,2 fois la durée de la plus courte des parties du signal pour lesquelles ledit intégrateur est actif.

6. Filtre passe-bas selon l'une quelconque des revendications 1 à 5, caractérisé en ce que le temps d'intégration du deuxième intégrateur (102) est compris entre 1 fois et 2 fois le temps d'intégration du premier intégrateur (101).

7. Filtre passe-bas selon l'une quelconque des revendications 1 à 6, caractérisé en ce que le point à tension fixe (Z) auquel est reliée l'entrée non inverseuse de l'amplificateur 111 du premier intégrateur 101 est le même que le point à tension fixe (Z') auquel est reliée l'entrée non inverseuse d'au moins l'un des amplificateurs des autres intégrateurs du filtre.

8. Filtre passe-bas selon l'une quelconque des revendications 1 à 7, caractérisé en ce que la source de courant d'intégration du premier intégrateur (1) et la source de courant de commande du second intégrateur (2) sont confondues en une seule source (14).

9. Filtre passe-bas selon l'une quelconque des revendications 1 à 8, caractérisé en ce que ledit filtre comporte une source (112) de courant de sortie et en ce que ledit comparateur de sortie (109a) commande l'état d'un interrupteur (109b) placé entre ladite source de courant de sortie et un branchement de sortie du filtre.

10. Filtre passe-bas selon la revendication 9, caractérisé en ce que ladite source de courant d'intégration du dernier intégrateur (90) et ladite source de courant de sortie sont confondues en une seule source (84).

11. Filtre passe-bas selon l'une quelconque des revendications 1 à 10, caractérisé en ce que une diode (4) est insérée en inverse entre l'entrée ($E_1$) et le premier comparateur à seuil (13).

12. Filtre passe-bas selon l'une quelconque des revendications 1 à 5 ou 7 à 11 pour signal symétrique, caractérisé en ce que les intégrateurs (101, 102) sont sensiblement identiques.

13. Filtre passe-bas selon l'une quelconque des revendications 1 à 12, caractérisé en ce que un comparateur à seuil et l'interrupteur qu'il commande sont réalisés par un transistor bipolaire (13) dont l'une des électrodes principales (403) est à la source de courant (12), l'autre (203) à l'entrée de l'amplificateur (11) correspondant, la base (303) étant à la tension de référence.

14. Filtre passe-bas selon l'une quelconque des revendications 1 à 13, caractérisé en ce que au moins un (31) desdits amplificateurs est constitué de deux transistors bipolaires (31a, 31b), le premier (31a) d'entrée et le deuxième (31b) de sortie, de même type et agencés selon le montage dit « Darlington normal », l'émetteur (131) du premier transistor dont la base (231) constitue l'entrée ($A_2$) dudit amplificateur attaquant la base (431) du deuxième transistor dont l'émetteur (531) est à la masse, les collecteurs (331, 631) des deux dits transistors étant reliés ensemble et à la source de courant d'intégration correspondante et constituant la sortie ($A'_2$) dudit amplificateur.

15. Filtre selon l'une quelconque des revendications 1 à 14, caractérisé en ce que les différents éléments en sont intégrés sur un bloc semiconducteur monolithique.

**Claims**

1. A low-pass filter for low-frequency signals comprising portions having one direction and other portions having the opposite direction relative to an average value, said filter specifically comprising a first (101) and a second (102) voltage-inverting integrator, connected in series, of which the first integrator (101) is mainly operative for portions of a first direction and the second integrator (102) for portions of the second direction, each of said integrators in particular comprising a voltage-inverting current amplifier (111, 121) between whose inverting input (M, P) and output (N, Q) a capacitor (110, 120) is included, the non-inverting input (Z, Z') being connected to a point of fixed voltage, characterized in that the first (101) and second (102) integrators also comprise a constant-integration-current source (104, 106) connected to the output (N, Q) of said amplifier, that the input (M, P) of each said amplifiers is connected to a constant-control-current source (103, 105) of said integrator via a switch (K, J) controlled by a threshold comparator (107a, 108a), that the input (E) of said filter is connected to the first threshold comparator (107a) of said first integrator (101), that the output (N) of said first integrator (101) is connected to the second threshold comparator (108a) of said second integrator (102), that the output (Q) of said second integrator (102) is connected to an output threshold comparator (109a) connected to the output (S) of the filter, that the capacitance values of said capacitors (111, 121), the currents supplied by the current sources (103, 105, 104, 106), the relative level of the input voltage and the threshold voltages of the comparators (107a, 108a, 109a) are such that the integration time of each of said integrators is greater than 0,1 and smaller than 1 times the duration of the shortest of the signal portions for which said integrator is operative, and that the discharge time of each of said integrators is, at the most, equal to said integration time of said integrator.

2. A low-pass filter as claimed in Claim 1, characterized in that between the output (Q) of the second integrator (102) and the input of the output-threshold-comparator (109a) there is arranged an additional voltage-inverting integrator (90), which also comprises :
— an additional voltage-inverting current amplifier (171) between whose inverting input (G) and output (H) an additional capacitor (170) is arranged, the non-inverting input being connected to a point of fixed voltage and
— an additional constant-integration-current source (176) connected to the output (H) of said amplifier, that the input (G) of said additional amplifier (171) is connected to a constant-control-current source (175) of said additional integrator via a switch (L) controlled by an inverter (180) threshold-comparator (178), whose output is connected to the output (Q) of the second integrator,
that the output (H) of said additional integrator is connected to the output of the filter (S), that the capacitance values of said capacitors (110, 120, 170) of said three integrators, the current gain factors of said amplifiers, the currents supplied by the current sources (103, 104, 105, 206, 175, 176), the relative level of the input voltage and the threshold voltages of the comparators (107a, 108a, 178a, 109a) are such that the integration time of each of said integrators is greater than 0.1 and smaller than 0.5 times the duration of the shortest of said signal portions of the second direction and that the discharge time of each of said integrators is, at the most, equal to said integration time of said integrator.

3. A filter as claimed in any of the Claims 1 and 2, characterised in that the integration time of said integrators is greater than 0.3 times the duration of the shortest of the signal portions for which said integrator is operative.

4. A filter as claimed in Claim 1, characterised in that the integration time of said integrators is smaller than 0.7 times the duration of the shortest of the signal portions for which said integrator is operative.

5. A filter as claimed in any of the Claims 1 to 4, characterised in that at least the discharge time of the capacitor (110) of the first integrator (101) lies between 0.01 and 0.2 times the duration of the shortest of the signals portions for which said integrator is operative.

6. A low-pass filter as claimed in any of the Claims 1 to 5, characterised in that the integration time of the second integrator (102) lies between 1 times and 2 times the integration time of the first integrator (101).

7. A low-pass filter as claimed in any of the Claims 1 to 6, characterised in that the point of fixed voltage (Z), to which the non-inverting input of the amplifier (111) of the first integrator (101) is connected, is the same as the point of the fixed voltage (Z') to which the non-inverting input of at least one of the amplifiers of the other integrators of the filter is connected.

8. A low-pass filter as claimed in any of the Claims 1 to 7, characterised in that the integration-current source of the first integrator (1) and the control-current source of the second integrator (2) are constituted by a single source (14).

9. A low-pass filter as claimed in any of the Claims 1 to 8, characterised in that said filter comprises an output-current source (112) and that said output comparator (109a) controls the state of a switch (109b) arranged between said-output-current source and an output tapping of the filter.

10. A low-pass filter as claimed in Claim 9, characterised in that said integration-current source of the last integrator (90) and said output-current source are constituted by a single source (84).

11. A low-pass filter as claimed in any of the Claims 1 to 10, characterised in that a diode (4) poled in the reverse direction is arranged between the input (E1) and the first threshold comparator (13).

12. A low-pass filter as claimed in any of the Claims 1 to 5, or 7 to 11 for symmetrical signals, characterised in that the integrators (101, 102) are substantially identical.

13. A low-pass filter as claimed in any of the Claims 1 to 12, characterised in that a threshold comparator and the switch which it controls are constructed by a bipolar transistor (13), of which one of the main electrodes (403) is connected to the current source (12), the other (203) to the input of the corresponding amplifier (11) and the base (303) to the reference voltage.

14. A low-pass filter as claimed in any of the Claims 1 to 13, characterised in that at least one (31) of said amplifiers is constituted by two bipolar transistors (31a, 31b) of the same type, the first one (31a) being the input transistor and the second one (31b) being the output transistor, which transistors are connected in « normal Darlington » arrangement. the emitter (131) of the first transistor, whose base (231) consitutes the input ($A_2$) of said amplifier, being connected to the base (431) of the second transistor, whose emitter (531) is connected to earth, the collectors (331, 631) of said two transistors being interconnected and being connected to the corresponding integration-current source and constituting the output ($A'_2$) of said amplifier.

15. A filter as claimed in any of the Claims 1 to 14 characterised in that the various elements are integrated on a monolithis semiconductor chip.

**Ansprüche**

1. Tiefpassfilter für Niederfrequenz-Signale, die in bezug auf einen Mittelwert Teile mit einer Polarität und andere Teile mit der entgegengesetzten Polarität umfassen, mit insbesondere einem ersten Spannungsumkehrintegrator (101) und einen zweiten Spannungsumkehrintegrator (102) in Serienschaltung, wobei der erste (101) hauptsächlich die Signalteile mit der ersten Polarität und der zweite (102) hauptsächlich die Teile mit der zweiten Polarität integriert und wobei ein jeder dieser Integratoren insbesondere einen Spannungsumkehr-Stromverstärker (111, 121) enthält, zwischen dessen invertierendem Eingang (M, P) und dem Ausgang (N, Q) ein Kondensator (110, 220) aufgenommen ist, während der nicht-invertierende Eingang (Z, Z') an einen Punkt mit fester Spannung angeschlossen ist, dadurch gekennzeichnet, dass der erste (101) und der zweite Integrator (102) je eine Integrationskonstantstromquelle (104, 106) enthalten, die an den Ausgang (N, Q) des Verstärkers angeschlossen ist, dass der Eingang (M, P) eines jeden Verstärkers an eine Steuer-Konstantstromquelle (103, 105) des Integrators über einen von einem Schwellenkomparator (107a, 108a) gesteuerten Schalter (K, J) angeschlossen ist, dass der Eingang (E) des Filters den ersten Schwellenkomparator (107a) des ersten Integrators (101) ansteuert, dass der Ausgang (N) des ersten Integrators (101) den zweiten Schwellenkomparator (108a) des zweiten Integrators (102) ansteuert, dass der Ausgang (Q) des zweiten Integrators (102) einen Ausgangsschwellenkomparator (109a) ansteuert, der mit dem Filterausgang (S) verbunden ist, und dass die Kapazität der Kondensatoren (110, 120), der Wert des Stromverstärkungskoeffizienten der Verstärker (111, 121), die Leistung der Stromquellen (103, 105, 104, 106), der relativen Eingangsspannungspegel und die Schwellenspannungen der Komparatoren (107a, 108a, 109a) derart sind, dass die Integrationszeit eines jeden der Integratoren höher als 0,1 und niedriger als das 1-fache der Dauer des kürzesten Teils der Signalabschnitte ist, die der Integrator integriert, und dass die Entladungszeit eines jeden Integrators höchstens gleich der Integrationszeit des betreffenden Integrators ist.

2. Tiefpassfilter nach Anspruch 1, dadurch gekennzeichnet, dass dem Ausgang (Q) des zweiten Integrators (102) und dem Eingang des Ausgangsschwellenkomparators (109a) ein Zusatz-Spannungsumkehrintegrator (90) angeordnet ist, der ebenfalls folgende Teile enthält:

— einerseits einen zusätzlichen Umkehr-Stromverstärker (171), zwischen dessen invertierenden Eingang (G) und dessen Ausgang (H) ein zusätzlicher Kondensator (170) angeordnet ist, während der nicht-invertierende Eingang mit einem Festspannungspunkt verbunden ist, und

— zum anderen eine Konstantstromquelle (176) für die zusätzliche Integration, angeschlossen an den Ausgang (H) dieses Verstärkers (171), dessen Eingang (G) mit einer Konstantstromquelle (175) für die Steuerung des Zusatzintegrators (90) über einen von einem Schwellenkomparator (178a) mit Umkehrstufe (180) gesteuerten Schalter (L), verbunden ist wobei der Eingang dieses Komparators von Ausgang (Q) des zweiten Integrators angesteuert wird, und dass der Ausgang (H) des Zusatzintegrators den Ausgangsschwellenkomparator (109a) ansteuert, dessen Ausgang mit dem Ausgang des Filters (S) verbunden ist, und dass die Kapazität der Kondensatoren (110, 120, 170) der drei Integratoren, der Wert des Stromverstärkungskoeffizienten der Verstärker, der Wert des Ausgangsstroms der Stromquellen (103, 104, 105, 206, 175, 176), der Wert des relativen Pegels der Eingangsspannung und der Schwellenspannungen der Komparatoren (107a, 108a, 178a, 109a), derart sind, dass die Integrationszeit eines jeden Integrators höher als das 0,1 und niedrigers oder gleich dem 0,5-fachen der Dauer des kürzesten der Signalabschnitte mit der zweiten Strom richtung ist, und dass die Entladungszeit eines jeden Integrators höchstens gleich der Integrationszeit des Integrators ist.

3. Tiefpassfilter nach einem der Ansprüche 1 und 2, dadurch gekennzeichnet, dass die Integrationszeit der Integratoren höher ist als das 0,3-Fache der Dauer der kürzesten der Signalabschnitte, für die der Integrator integriert.

4. Tiefpassfilter nach Anspruch 1, dadurch gekennzeichnet, dass die Integrationszeit der Integratoren kleiner als das 0,7-Fache der Dauer des kürzesten Signalabschnitts ist, für den der Integrator integriert.

5. Tiefpassfilter nach einem der Ansprüche 1 bis 4, dadurch gekennzeichnet, dass die Entladungszeit des Kondensators (110) des ersten Integrators (101) zumindest zwischen dem 0,01- und dem 0,2-fachen der Dauer des kürzesten Signalabschnitts liegt, für den der Integrator aktiv ist.

6. Tiefpassfilter nach einem der Ansprüche 1 bis 5, dadurch gekennzeichnet, dass die Integrationszeit des zweiten Integrators (102) zwischen dem 1-fachen und dem 2-fachen der Integrationszeit des ersten Integrators (101) liegt.

7. Tiefpassfilter nach einem der Ansprüche 1 bis 6, dadurch gekennzeichnet, dass der Festspannungspunkt (Z), mit dem der nicht invertierende Eingang des Verstärkers (111) des ersten Integrators 101 verbunden ist, und der Festspannungszeit (Z') die selben sind, mit dem der nicht invertierende Eingang zumindest eines der Verstärker der anderen Integratoren des Filters verbunden ist.

8. Tiefpassfilter nach einem der Ansprüche 1 bis 7, dadurch gekennzeichnet, dass die Integrationsstromquelle des ersten Integrators (1) und die Steuerstromquelle des zweiten Integrators (2) zu einer einzigen Quelle (14) zusammengefügt sind.

9. Tiefpassfilter nach einem der Ansprüche 1 bis 8, dadurch gekennzeichnet, dass das Filter eine Ausgangsstromquelle (112) enthält und dass der Ausgangskomparator (109a) den Zustand eines Schalters (109b) zwischen der Ausgangsstromquelle und einem Ausgangsabzweig des Filters steuert.

10. Tiefpassfilter nach Anspruch 9, dadurch gekennzeichnet, dass die Integrationsstromquelle des letzten Integrators (90) und die Ausgangsstromquelle zu einem einzigen Quelle (84) zusammengefügt sind.

11. Tiefpassfilter nach einem der Ansprüche 1 bis 10, dadurch gekennzeichnet, dass zwischen dem Eingang ($E_1$) und dem ersten Schwellenkomparator (13) eine Diode (4) gesperrt angeschlossen ist.

12. Tiefpassfilter nach einem der Ansprüche 1 bis 5 oder 7 bis 11 für ein symmetrisches Signal, dadurch gekennzeichnet, dass die Integratoren (101, 102) weitgehend identisch sind.

13. Tiefpassfilter nach einem der Ansprüche 1 bis 12, dadurch gekennzeichnet, dass ein Schwellenkomparator und der von ihm gesteuerte Schalter von einem Bipolartransistor (13) gebildet werden, dessen eine Hauptelektrode (403) an die Stromquelle (12), dessen andere Hauptelektrode (203) an den Eingang des entsprechenden Verstärkers (11) angeschlossen ist, und dessen Basis (303) die Bezugsspannung führt.

14. Tiefpassfilter nach einem der Ansprüche 1 bis 13, dadurch gekennzeichnet, dass zumindest einer (31) der Verstärker aus zwei Bipolartransistoren (31a, 31b) vom gleichen Leitfähigkeitstyp und in einer « normalen Darlington »-Schaltung angeordnet besteht, von denen der erste (31a) den Eingang und der zweite (31b) den Ausgang bildet, wobei der Emitter (131) des ersten Transistors, dessen Basis (231) den Eingang ($A_2$) des Verstärkers darstellt, die Basis (431) des zweiten Transistors ansteuert, dessen Emitter (531) mit Masse verbunden ist, wobei die Kollektoren (331, 631) der zwei Transistoren miteinander und mit der entsprechenden Integrationsstromquelle verbunden sind und den Ausgang ($A'_2$) des Verstärkers bilden.

15. Tiefpassfilter nach einem der vorangehenden Ansprüche 1 bis 14, dadurch gekennzeichnet, dass die verschiedenen Elemente in einem monolithischen Halbleiterblock integriert sind.

FIG.1

FIG.2

**0 014 506**

FIG.3

**0 014 506**

FIG.4

3

FIG.5

4

FIG.6

FIG.7

0 014 506

FIG.8

7

FIG.9

FIG.10

**FIG.11**

FIG.12